(19) Europäisches Patentamt
European Patent Office
Office européen des brevets

(11) Veröffentlichungsnummer: **0 069 069**
**B1**

(12) **EUROPÄISCHE PATENTSCHRIFT**

(45) Veröffentlichungstag der Patentschrift: **02.03.88**

(51) Int. Cl.⁴: **G 03 C 1/68,** G 03 F 7/00, C 08 F 20/00

(21) Anmeldenummer: **82810259.0**

(22) Anmeldetag: **14.06.82**

(54) **Polymerisierbare Zusammensetzungen und die daraus durch Polymerisation erhaltenen Produkte.**

(30) Priorität: **19.06.81 GB 8119036**
**24.03.82 GB 8208667**

(43) Veröffentlichungstag der Anmeldung:
**05.01.83 Patentblatt 83/01**

(45) Bekanntmachung des Hinweises auf die Patenterteilung:
**02.03.88 Patentblatt 88/09**

(84) Benannte Vertragsstaaten:
**BE CH DE FR GB IT LI NL SE**

(56) Entgegenhaltungen:
**EP-A-0 000 890**
**EP-A-0 031 305**
**EP-A-0 033 896**
**GB-A-1 560 822**
**GB-A-2 012 781**
**US-A-4 216 306**
**US-A-4 243 793**

(73) Patentinhaber: **CIBA-GEIGY AG**
**Klybeckstrasse 141**
**CH-4002 Basel (CH)**

(72) Erfinder: **Irving, Edward, Dr.**
**41, Swaffham Road**
**Burwell Cambridge CB5 0AN (GB)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 069 069 B1

**Beschreibung**

Vorliegende Erfindung betrifft Zusammensetzungen, die aus einem Polymercaptan mit mindestens zwei Mercaptangruppen (—SH) und einer Verbindung mit sowohl midestens zwei, vorzugsweise mindestens drei, Aethylendoppelbindungen als auch mindestens einer freien Carboxylgruppe bestehen. Ferner betrifft sie die Polymerisation solcher Zusammensetzungen mittels aktinischer Strahlung und/oder hitzeaktivierbarer Radikalkatalysatoren sowie die Verwendung der polymerisierten Produkte als Oberflächenbeschichtungen, als Klebstoffe und in verstärkten Verbundstoffen, jedoch insbesondere in gedruckten Schaltungen.

In der U.S. Patentschrift Nr. 4 220 513 sind Zusammensetzungen beschreiben, die aus (1) einer Verbindung, die im selben Molekül sowohl mindestens eine 1,2-Epoxidgruppe als auch mindestens zwei unter Allyl, Methallyl-. und 1-Propenylgruppen ausgewählte Gruppen enthält, z.B. 2,2-Bis-(3-allyl-4-(glycidyloxy)-phenyl)-propan und Bis-(3-(1-propenyl)-4-glycidyloxy)-phenyl)-methan, und (2) einer Verbindung mit mindestens zwei an aliphatische Kohlenstoffatome gebundenen Mercaptangruppen pro Molekül, z.B. Pentaerythrit-tetrathioglykolat, bestehen.

Die Zusammensetzungen werden durch Reaktion der Mercaptangruppen mit den Allyl, Methallyl- oder 1-Propenylgruppen unter der Einwirkung von aktinischer Strahlung oder Radikalkatalysatoren zur Polymerisation gebracht.

Solche Zusmmensetzungen, die ferner (3) ein heisshärtbares Vernetzungsmittel für Polyepoxide enthalten, sind ebenfalls beschrieben; die polymerisierten, mehr als eine Epoxidgruppe pro Durchschnittsmolekül enthaltenden Produkte könnten also nachträglich in situ vernetzt werden.

In der bekanntgemachten britischen Patentanmeldung Nr. 2 012 781 A werden ähnliche Zusammensetzungen offenbart, bei denen die Komponente (1) mindestens eine phenolische Hydroxylgruppe anstelle der mindestens einen Epoxidgruppe enthält, z.B. 2,2-Bis-(3-allyl-4-hydoxyphenyl)-propan und Bis-(3-(1-propenyl)-4-hydroxyphenyl)-methan, wobei die Komponente (3) entsprechend ein hitzeaktivierbares Vernetzungsmittel für Phenol/Aldehyd-Novolakharze ist. Die mehr als eine phenolische Hydroxylgruppe pro Durchschnittsmolekül enthaltenden, polymerisierten Produkte könnten ebenfalls nachträglich durch Erhitzen in situ vernetzt werden.

Es wurde nun gefunden, dass gewisse, Acrylat- oder Methacrylatestergruppen enthaltende Verbindungen in Gegenwart gewisser Mercaptane sehr rasch durch Belichtung mit aktinischer Strahlung oder Einwirkung von Radikalkatalysatoren unter Bildung von Produkten mit wertvollen Eigenschaften zur Polymerisation gebracht werden können. Die dabei eingesetzten Acrylat- oder Methacylatester enthalten ferner Allyl-, Methallyl und/oder 1-Propenylgruppen. Es ird angenommen, dass, obwohl die Nützlichkeit dieser Erfindung nicht von der Richtigkeit dieser Annahme abhängt, die Doppelbindungen vom Allyltyp bevorzugt mit den Mercaptangruppen reagieren, so dass die über die Doppelbindungen in den Acryl- oder Methacrylgruppen verlaufenden Polymerbildungsvorgänge erleichtert werden. Ungeachtet der möglichen Reaktionsmechanismen wurde gefunden, dass die Zusammensetzungen sehr rasch unter Bildung von Oberflächenbeschichtungen und Klebverbindungen polymerisieren.

Bei der sogenannten Negativ-Resistmethode zur Herstellung von gedruckten Schaltungen beschichtet man ein Substrat mit einer photopolymerisierbaren Zusammensetzung und belichtet die Beschichtung durch ein bildtragendes Diapositiv mit im wesentlichen durchsichtigen und im wesentlichen undurchsichtigen Stellen hindurch mit aktinischer Strahlung, so dass an den von der Strahlung getroffenen Stellen der Beschichtung eine Polymerisation stattfindet. Andernfalls kann man ein solche Belichtung mit rechnergesteuerten Abtastlaserstrahlen anstelle ines solchen Diapositivs durchführen. Die Abbildung wird dan "entwickelt", indem man die Stellen, wo keine Polymerisation stattgefunden hat, d.h. die nicht von der aktinischen Strahlung getroffen wurden, mit einem geeigneten Lösungsmittel weglöst. Danach kann man das Substrat, üblicherweise Kupfer, mit Aetzflüssigkeiten behandeln, so dass die nicht durch die verbleibenden Anteile der Zusammensetzung geschützten Stellen geätzt werden. Bei der weitern Verarbeitung, wie bei der Herstellung von Vielschichtplatten, kann eine mechanische Entfernung der Schicht aus verbliebener Zusammensetzung erforderlich sein.

Nachteile des derzeit angewandten Verfahrens sind, dass organische Lösungsmittel mit ihren innewohnenden Toxizitäts- und Brennbarkeitsgefahren häufig zum Entikkeln verwendent werden, und dass mechanische Methoden zur Entfernung der photopolymerisierten Zusammensetzung die gedruckte Schaltung beschädigen können.

Wie schon angegeben, enthalten die Ester ferner Carbonsäuregruppen; erfolgt die Belichtung mit aktinischer Strahlung wie durch ein Negativ mit im wesentlichen undurchsichtigen Stellen hindurch, so kann man die Zusammensetzung an den unbelichteten Stellen durch Behandlung mit einer wässrig-alkalischen Lösung entfernen, wegen der Salzbildung an den Carbonsäuregruppen. Die Verwendung eines organischen Lösungsmittels, mit den begleitenden Nachteilen der Toxizität und/oder Brennbarkeit, für diesen Zweck wird dadurch vermieden. Ent weiterer Vorzug ist, dass die polymerisierte Zusammensetzung später durch Anwendung von stärker basischen wässrigen Lösungen gewünschtenfalls entfernt werden kann.

U.S. Patentschrift Nr. 4 120 721 beschreibt strahlungshärtbare Zusammensetzungen zur Verwendung in Beschichtungs- und Bebilderungsverfahren. Die Zusammensetzungen bestehen aus mehrfach ungesättigten Urethanen mit Acryl- oder Methacrylendgruppen, eine Vinylmonomer, vorzugsweise einem

Acryl- oder Methacrylsäureester, einem Polymercaptan mit mindestens zwei —SH—Gruppen pro Molekül und einem Photoinitiator. Um das Polyurethan mit Acryl- oder Methacrylendgruppen zu erhalten, lässt man ein Diisocyanat mit einem hydroxylsubstituierten Acrylat oder Methacrylat in einer solchen Menge reagieren, dass ein stöchiometrisches Aequivalent freier Isocyanatgruppen im Reaktionsprodukt verbleibt, und lässt dann die Isocyanatgruppen mit dem stöchiometrischen Aequivalent von Hydroxylgruppen in einem mehrwertigen Alkohol, vorzugsweise einem Polyäthylenglykol oder Polypropylenglykol, reagieren. Neben den etwa fünfzig als geeignet angeführten Hydroxyalkylacrylaten und -methacrylaten finden sich 2-Hydroxy-3-(allyloxy)-propylacrylat, 2-Hydroxy-3-cinnamylpropylacrylat, 2-Hydroxy-3-(crotonyloxy)-propylacrylat sowie die entsprechenden Methacrylate. Die speziell beschriebenen Polymeren wurden aus einem Hydroxyalkylacrylat oder Hydroxyalkylmethacrylat hergestellt und weisen keine Doppelbindungen vom Allyltyp auf. Es besteht kein Hinweis darauf, dass die Verwendung von Urethanen, die Acryl- oder Methacrylendgruppen enthalten und sich bon Hydroxyalkylacrylaten mit zusätzlichen Aethylendoppelbindungen ableiten, irgendeinen Vorteil bringen würde.

In der britischen Patentschrift Nr 1 474 715 sind photopolymerisierbare Acrylester beschrieben, die freie Carbonsäuregruppen enthalten und durch Umsetzung zumindest eines Dianydrids einer Polycarbonsäure mit einem mindesten zwei Acrylestergruppen enthaltenden Alkohol hergestellt werden. In den U.S. Patentschriften Nr. 4 079 183, 4 181 807 und 4 179 577 sind photopolymerisierbare Verbindungen beschrieben, die freie Carbonsäuregruppen und einige spezielle, zwei aromatische Ringe verknüpfende ungesättigte Gruppen enthalten, und die man durch Umsetzung zumindest eines Dianhydrids einer Polycarbonsäure mit alkoholichen Hydroxylgruppen eines mindestens eine der angegebenen ungesättigten Gruppen enthaltenden Alkohols erhält. In allen diesen Veröffentlichungen wird die Entfernung des nicht photopolymerisierten Materials durch Berührung mit einer wässrigalkalischen Lösung beschrieben, doch ist die Photopolymerisation solcher Materialien in Gegenwert eines Polymercaptans nicht erwähnt.

Gegenstand dieser Erfindung sind demnach polymerisierbare Zusammensetzungen, welche dadurch gekennzeichnet sind, dass sie aus

(a) einer Verbindung, die im Molekül (i) mindestens eine unter Acryloyloxy- und Methacryloyloxygruppen ausgewählte Gruppe, (ii) mindestens eine unter jeweils entweder direkt oder über ein Sauerstoffatom oder eine Oxycarbonylgruppe (—OCO—) an ein zu einem aromatischen oder cycloaliphatischen Kern gehöriges Kohlenstoffatom gebundenen Allyl-, Methallyl- und 1-Propenylgruppen ausgewählte Gruppe und (iii) mindestens eine Carbonsäuregruppe (—COOH) enthält, und

(b) einem solchen Anteil einer Verbindung, die pro Molekül mindestens zwei direkt an ein bzw. mehrere aliphatische Kohlenstoffatome gebundene Mercaptangruppen enthält, dass mindestens 0,8 solche Mercaptangruppen auf eine unter Allyl-, Methallyl- und 1-Propenylgruppen ausgewählte Gruppe in (a), jedoch weniger als 1,0 solche Mercaptangruppen auf eine unter Acryloyl, Methacryloyl-, Allyl-, Methallyl- und 1-Propenylgruppen ausgewählte Gruppe in (a) kommen, bestehen, wobei die Summe der gruppen (i) und (ii) ewei oder mindestens drei bedeutet.

Gegenstand dieser Erfindung sind ferner ein Verfahren zur Polymerisation solcher Zusammensetzungen, bei dem man diese aktinischer Strahlung oder der Einwirkung eines Radikalkatalysators aussetzt, sowie die nach einem solchen Verfahren erhaltenen, polymerisierten Produkte. Die EP—A—O 031 305 (AS 54(3) EPÜ) beschreibt polymerisierbare Zusammensetzungen enthaltend die Komponenten (a) und (b), in welchen die Komponente (a) keine Carbonsäuregruppe enthält und die Summe der Gruppen (i) und (ii) mindestens drei beträgt. Die Bestrahlung dieser Zusammensetzungen durch ein Negativ und Entwicklung mit Lösungsmitteln resultiert in der Entfernung der unbelichteten Stellen und Erzeugung eines Negativbildes.

In den erfindungsgemässen Zusammensetzungen enthält die Komponente (1) vorzugsweise keine Aethylendoppelbindungen ausser denen in Acryloyloxy-, Methacryloyloxy-, Allyl-, Methallyl- und 1-Propenylgruppen, und die Summe der Gruppen (i) und (ii) pro Molekül beträgt vorzugsweise mindestens drei. Bevorzugt weist die Verbindung ein Molekulargewicht von höchstens 5 000 auf. Die Acryloyloxy- oder Methacryloyloxygruppe bzw. -gruppen sind vorzugsweise jeweils über eine Gruppe der Formel

$$-CH_2\underset{\displaystyle OR}{\underset{|}{C}}HCH_2- \qquad \text{I}$$

worin R entweder für ein Wasserstoffatom oder für den einwertigen Acylrest einer mindestens zweibasischen Carbonsäure (d.h. den Rest nach Entfernung der einen Teil der Carbonsäuregruppe bildenden und über die Carbonylgruppe dieser Carbonsäuregruppe an das dargestellte Saurestoffatom gebundenen Hydroxylgruppe) steht, an einen aromatischen, cycloaliphatischen oder heterocyclische Kern gebunden.

Die Gruppe der Formel I ist vorzugsweise entweder über ein Sauerstoffatom an ein Kohlenstoffatom eines aromatischen Kerns oder an ein zu einem heterocyclischen Ring gehöriges Stickstoffatom gebunden. Ferner entspricht R vorzugsweise der Formel

$$-CO-R^1-COOH \qquad \text{II}$$

worin $R^1$ eine gegebenenfalls durch eine oder mehrere Allyl-, Methallyl- oder 1-Propenylgruppen oder eine oder mehrere Carbonsäuregruppen substituierte Alkylen-, Arylen- oder Aralkylengruppe darstellt, wobei diese Alkylengruppe bzw. der Alkylenteil der Aralkylengruppe 2 bis 10 Kohlenstoffatome sowie diese Arylengruppe bzw. der Arylenteil der Aralkylengruppe 6 bis 10 Kohlenstoffatome aufweisen.

Vorzugsweise enthält die Komponente (a) mindestens zwei und höchstens sechs unter Acryloyloxy- und Methacryloyloxygruppen ausgewählte Gruppen pro Molekül, mindestens zwei und höchstens fünfzehn unter Allyl-, Methylallyl- und 1-Propenylgruppen ausgewählte Gruppen pro Molekül sowie mindestens zwei und höchstens fünfzehn Carbonsäuregruppen pro Molekül.

Ferner werden als Komponente (a) auch Verbindungen bevorzugt, in denen die Gesamtzahl der unter Acryloyloxy- und Methacryloyloxygruppen ausgewählten Gruppen im Molekül gleich der Gesamtzahl der unter Allyl-, Methallyl- und 1-Propenylgruppen ausgewählten Gruppen in jenem Molekül und ebenfalls gleich der Gesamtzahl Carbonsäuregruppen in jenem Molekül ist.

Der bzw. die aromatische(n) Kern(e) in der Komponente (a) sind vorzugsweise ein Benzolkern oder Naphthalinkern.

Weitere bevorzugte Komponenten (a) sind mehrwertige Phenole, in denen mindestens zwei phenolische Hydroxylgruppen über eine carbonsäurehaltige Gruppe der Formel I oder II mit Acryloyl- oder Methacryloylgruppen verestert sowie mindestens zwei phenolische Hydroxylgruppen direkt mit unter Allyl-, Methallyl- und 1-Propenylgruppen ausgewählten Gruppen veräthert sind.

Als Komponente (a) werden mehrwertige Phenole besonders bevorzugt, in denen mindestens zwei phenolische Hydroxylgruppen über eine carboxylhaltige Gruppe der Formel I oder II mit unter Acryloyl- und Methacryloylgruppen ausgewählten Gruppen verestert sind, wobei das mehrwertige Phenol an Kohlenstoffatomen in einem oder mehreren Benzol- oder Naphthalinkern(en) direkt durch mindestens zwei unter Allyl-, Methallyl- und 1-Propenylgruppen ausgewählten Gruppen substituiert ist, insbesondere solche Verbindungen, in denen diese Gruppen sich in ortho-Stellung zu den besagten Acryloyl- oder Methacryloylgruppen befinden.

Beispiele für als Komponente (a) geeignete Verbindungen sind solche der folgenden Formeln:

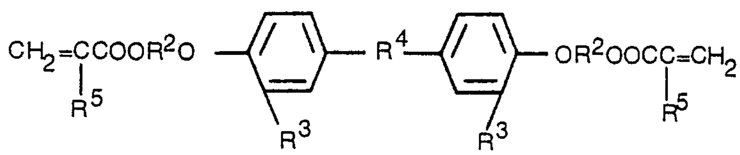

III

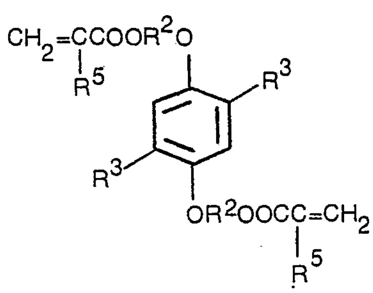

IV

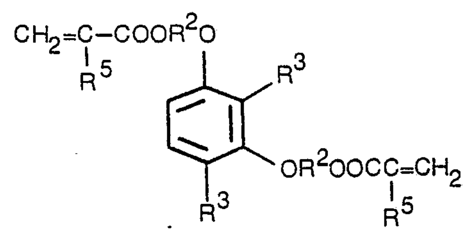

V

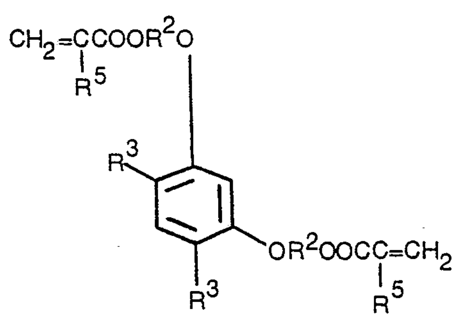

VI

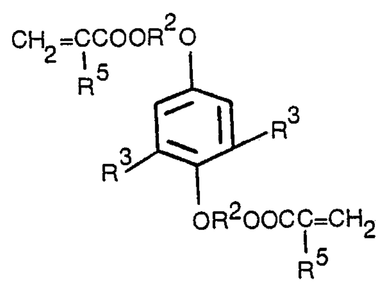

VII

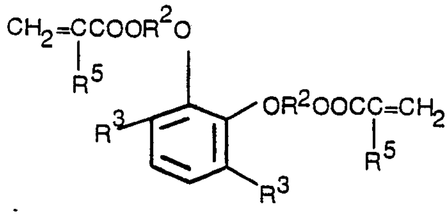

VIII

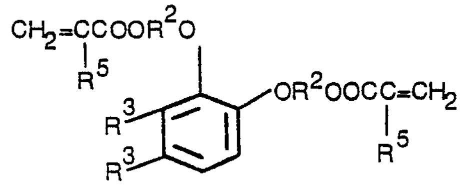

IX

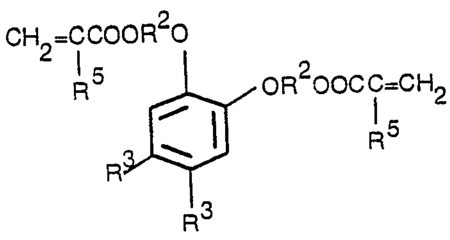

X

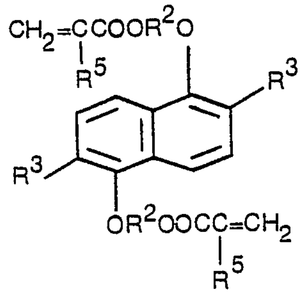

XI

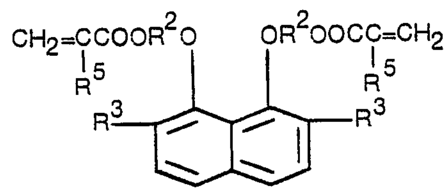

XII

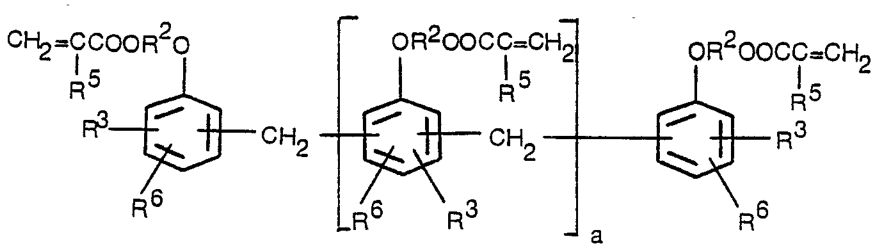

XIII

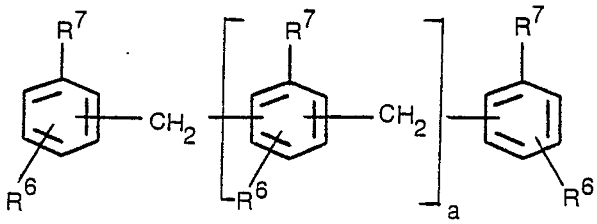

XIV

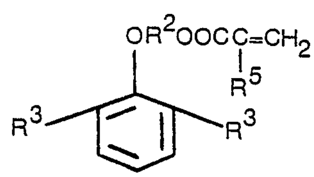

XV

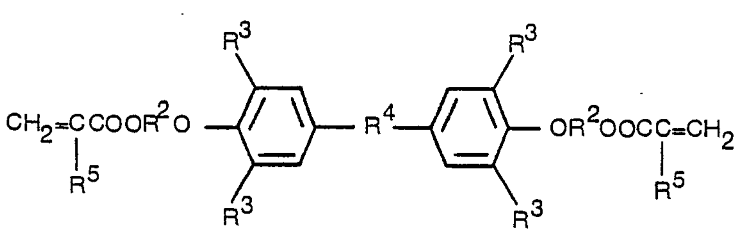

XVI

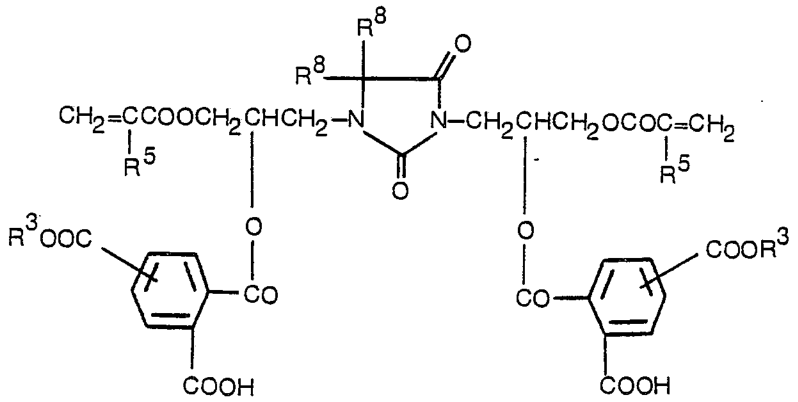

XVII

und

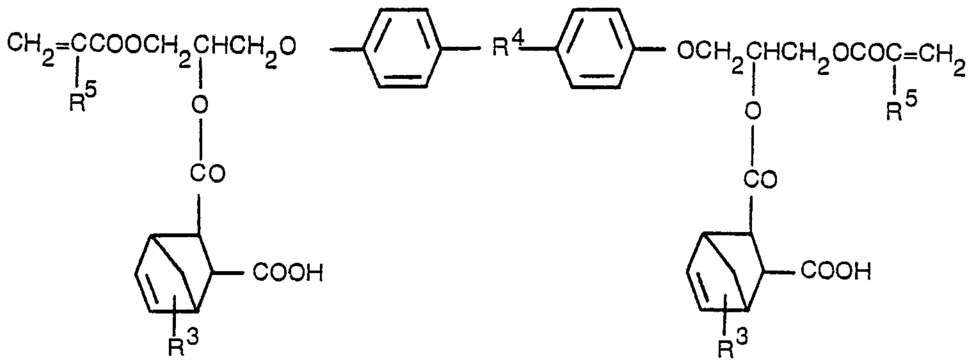

XVIII

worin a eine ganze Zahl von 1 bis 6 ist, $R^2$ jeweils eine carbonsäurehaltige Gruppe der Formel I, $R^3$ jeweils eine Allyl-, Methallyl- oder 1-Propenylgruppe, $R^4$ eine Kohlenstoff-Kohlenstoffbindung, eine Alkyle- oder Alkylidengruppe mit bis zu 5 Kohlenstoffatomen, ein Aethersauerstoffatom, ein Schwefelatom oder eine Gruppe der Formel —CO—, —SS—, —SO— oder —$SO_2$—, $R^5$ jeweils ein Wasserstoffatom oder eine Methylgruppe, $R^6$ jeweils ein Wasserstoff-, Chlor- oder Bromatom oder eine Alkylgruppe mit 1 bis 4 Kohlenstoffatomen, $R^7$ jeweils eine Gruppe der Formel $CH_2{=}C(R^5)COOR^2O$— oder eine Allyloxy-, Methallyloxy- oder 1-Propenyloxygruppe, derart dass mindestens ein $R^7$ eine solche Gruppe der Formel $CH_2{=}C(R^5)COOR^2O$— und mindestens zwei $R^7$ je eine Allyloxy-, Methallyloxy- oder 1-Propenyloxygruppe darstellen, und $R^8$ eine Alkylgruppe mit 1 bis 10 Kohlenstoffatomen, eine Aralkylgruppe mit 7 bis 16 Kohlenstoffatomen oder eine Arylgruppe mit 6 bis 10 Kohlenstoffatomen bedeuten, mit der Massgabe, dass sich in Formeln XIII und XIV die —$CH_2$— und $R^3$-Gruppen jeweils in ortho- oder para-Stellung zur angegebenen Gruppe $CH_2{=}C(R^5)COOR^2O$— und $R^7$— befinden.

Spezifische Beispiele für als Komponente (a) geeignete Verbindungen sind die Teilester der Bernstein-, Malein-, Glutar-, Adipin-, Phthal-, Tetrahydrophthal-, Hexahydrophthal-, Endomethylenetetrahydrophthal-, Pyromellith- oder Trimellithsäure mit den folgenden Alkoholen:

2,2 - Bis - (3 - allyl - 4 - (3 - (methacryloyloxy) - 2 - hydroxypropoxy) - phenyl) - propan, Bis - (3 - allyl - 4 - (3 - methacryloyloxy) - 2 - hydroxypropoxy) - phenyl) - methan, 2,2 - Bis - (3 - methallyl - 4 - (3 - (methyacryloyloxy) - 2 - hydroxypropoxy) - phenyl) - propan, Bis - (3 - methallyl - 4 - (3 - (methacryloyloxy) - 2 - hydroxypropoxy) - phenyl) - methan, 2,2 - Bis - (3 - (1 - propenyl) - 4 - (3 - (methacryloyloxy) - 2 - hydroxypropoxy) - phenyl) - propan, Bis - (3 - (1 - propenyl) - 4 - (3 - (methacryloyloxy) - 2 - hydroxypropoxy) - phenyl) - methan und deren acryloylanaloge;

1,3 - Diallyl - 2 - (2 - hydroxy - 3 - (methacryloyloxy) - propoxy) - benzol, 1,3 - Dimethallyl - 2 - (2 - hydroxy - 3 - (methacryloyloxy) - propoxy) - bonzol, 1,3 - Di - (1 - propenyl) - 2 - (2 - hydroxy - 3 - (methacryloyloxy) - propoxy) - benzol un deren Acryloylanaloge; und

2,2 - Bis - (3,5 - diallyl - 4 - (3 - methacryloyloxy) - 2 - hydroxypropoxy) - phenyl) - propan, Bis - (3,5 - diallyl - 4 - (3 - (methacryloyloxy) - 2 - hydroxypropoxy) - phenyl) - methan, 2,2 - Bis - (3,5 - dimethylallyl - 4 - (3 - (methacryloyloxy) - 2 - hydroxypropoxy) - phenyl) - propan, Bis - (3,5 - dimethallyl - 4 - (3 - (methacryloyloxy) - 2 - hydroxypropoxy) - phenyl) - methan, 2,2 - Bis - (3,5 - di - (1 - propenyl) - 4 - (3 - (methacryloyloxy) - 2 - hydroxypropoxy) - phenyl) - propan und Bis - (3,5 - di - (1 - propenyl) - 4 - (3 - (methacryloyloxy) - 2 - hydroxypropoxy) - phenyl) - methan und deren Acryloylanaloge.

Weitere als Komponente (a) verwendbare Verbindungen enthalten eine bis vier Carbonsäuregruppen, zwei Acryloyloxy- oder Methacryloyloxygruppen und nur eine Allyl-, Methallyl- oder 1-Propenylgruppe pro Molekül. Die letztere Gruppe kann an eine Oxycarbonylgruppe gebunden sein, die ihrerseits direkt mit einem zu einem aromatischen Kern gehörigen Kohlenstoffatom verknüpft ist, wie in solchen der Formel.

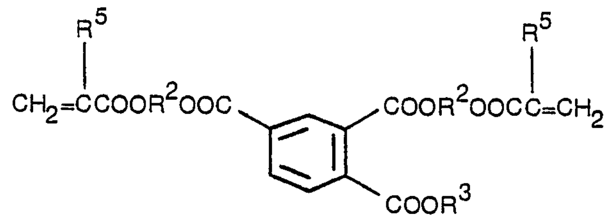

XIX

oder

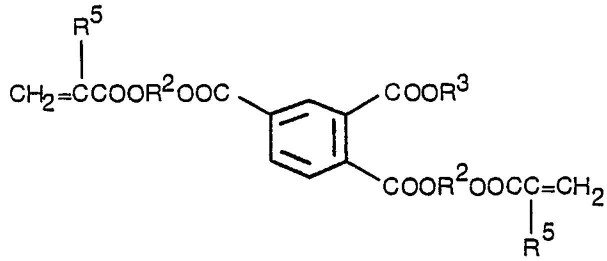

XX

worin $R^2$, $R^3$ und $R^5$ jeweils die unter Formel II engegebenen Bedeutungen haben.

Spezielle Beispiele für Verbindungen der Formel XIX oder XX sind die Teilester der Bernstein-, Malein-, Glutar-, Adipin-, Phthal-, Tetrahydrophthal-, Hexahydrophthal-, Endomethylentetrahydrophthal- oder Trimellithsäure mit den folgenden Alkoholen:

1 - (Allyloxycarbonyl) - 2,4 - bis - (3 - (methacryloyloxy) - 2 - hydroxypropoxycarbonyl) - benzol, 1 - (Allyloxycarbonyl) - 2,5 - bis - (3 - (methacryloyloxy) - 2 - hydroxypropoxycarbonyl) - benzol, 1 - (Methallyloxycarbonyl) - 2,4 - bis - (3 - (methacryloyloxy) - 2 - hydroxypropoxycarbonyl) - benzol, 1 - (Methallyloxycarbonyl) - 2,5 - bis - (3 - (methacryloyloxy) - 2 - hydroxypropoxycarbonyl) - benzol, 1 - (1 - Propenyloxycarbonyl) - 2,4 - bis - (3 - (methacryloyloxy) - 2 - hydroxypropoxycarbonyl) - benzol, 1 - (1 - Propenyloxycarbonyl) - 2,5 - bis - (3 - (methacryloyloxy) - 2 - hydroxypropoxycarbonyl) - benzol und die entsprechenden Acryloyloxyverbindungen.

Ferner Kann man als Komponente (a) Produkte verwenden, die sechs oder mehr (z.B. zwölf) Allyl-, Methallyl- oder 1-Propenylgruppen pro Molekül enthalten und nach Verfahren erhältlich sind, bei denen Vorverlängerung eintritt. Zum Beispiel kann man einen Diglycidyläther eines in dem bzw. den aromatischen Kern(en) durch eine oder mehrere Allyl-, Methallyl- oder 1-Propenylgruppen substituierten, zweiwertigen Phenols mit einem zweiwertigen Phenol, einem zweiwertigen Alkohol, eine Dicarbonsäure oder einem Hydantoin mit zwei freien -NH-Gruppen in dem bzw. den Hydantoinring(en) vorverlängern. Anschliessend kann man das vorverlängerte Produkt an den phenolischen oder den neugebildeten sekundären Hydroxylgruppen mit Glycidylacrylat oder Glycidylmethacrylat bzw. Acryloylchlorid oder Methacryloylchlorid oder an den Epoxidendgruppen mit Acrylsäure oder Methacrylsäure reagieren lassen und das Produkt mit dem Anhydrid einer Di- oder Polycarbonsäure zur Umsetzung bringen.

Andere vorverlängerte Produkte mit sechs oder mehr Allyl-, Methallyl- oder 1-Propenylgruppen sind durch Vorverlängerung von Diglycidyläthern zweiwertiger Phenole, Diglycidyläthern zweiwertiger Alkohole oder Di-(N-glycidyl)-hydantoinen wie 1,3-Diglycidylhydantoin und 3,3'-Diglycidyl-1,1'-methylenbis-(hydantoin) mit einem in dem (den) aromatischen Kern(en) durch eine oder mehrere Allyl, Methallyl- oder 1-Propenylgruppen substituierten zweiwertigen Phenol und anschliessende Umsetzung an den phenolischen oder neugebildeten sekundären Hydroxylgruppen mit Glycidylacrylat, Glycidylmethacrylat, Acryloylchlorid oder Methacryloylchlorid oder mit Acrylsäure oder Methacrylsäure an den Epoxidendgruppen und Umsetzung des Produkts mit dem Anhydrid einer Di- oder Polycarbonsäure erhältlich.

Weitere verwendbare Komponenten (a) sind Benzophenonderivative der Formel

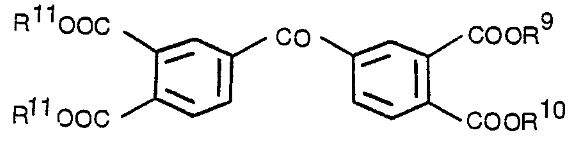

XXI

worin eines von $R^9$ und $R^{10}$ bzw. $R^{11}$ und $R^{12}$ die gleiche Bedeutung haben und je für eine Allyl- oder Methallylgruppe stehen und die verbleibenden Symbole $R^9$ und $R^{10}$ bzw. $R^{11}$ und $R^{12}$ für den Rest eines Alkohols nach Wegnahme einer alkoholischen Hydroxylgruppe stehen, wobei dieser Rest sowohl eine Carbonsäuregruppe als auch eine Acryloyloxy- oder Methacryloyloxygruppe enthält.

Vorzugweise stellen die verbleibenden Symbole $R^9$ und $R^{10}$ bzw. $R^{11}$ und $R^{12}$ jeweils eine Gruppe der Formel

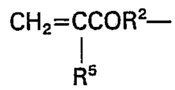

XXII

dar, worin $R^2$ und $R^5$ die unter der Formel III angegebenen Bedeutungen haben.

Weitere zur Verwendung als Komponente (a) geeignte Verbindungen entsprechen der Formel

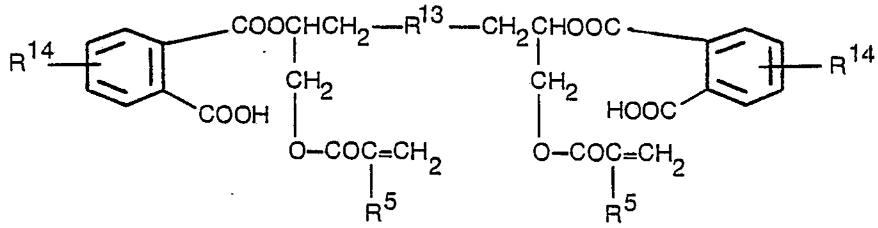

XXIII

worin $R^5$ die unter Formel III angegebene Bedeutung hat, $R^{13}$ eine Gruppe der Formel

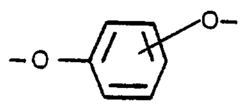

XXIV

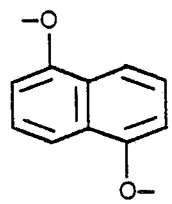

XXV

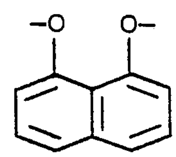

XXVI

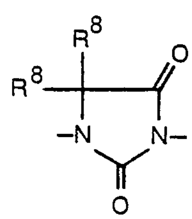

XXVII

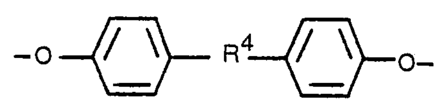

XXVIII

(worin $R^4$ und $R^8$ die unter Formel III angegebenen Bedeutungen haben) und $R^{13}$ eine Allyl-, Methallyl-, 1-Propenyl-, Allyloxycarbonyl-, Methallyloxycarbonyl-, 1-Propenyloxycarbonyl-, Diallylamino-, Dimethylallylamino- oder Di-(1-propenyl)-aminogruppe bedeuten.

Die meisten vorbekannten, bei Belichtung mit aktinicher Strahlung polymerisierenden Substanzen werden zusammen mit einem Photoinitiator wie Benzoin und dessen Alkyläthern eingesetzt, um die zur Polymerisation erforderliche Belichtungszeit zu verkürzen. Manchmal ist jedoch die Verwendung eines Initiators unzweckmässig. So kann er die elektrischen Eigenschaften des Polymeren verändern. Er kann sich beim Erhitzen verflüchtigen, so dass er zur Verwendung in mehrschichtigen gedruckten Schaltungen ungeeignet wird; deshalb wird bei deren Herstellung häufig nach Durchführung eines Metallätzvorgangs das Polymer entfernt, was die Kosten der Schichtstoffe erhöht und die Metalloberfläche beschädigen kann.

Die Herstellung photopolymerisierbarer Substanzen, die einen Rest gewisser olefinisch ungesättigter Monocarbonsäuren, insbesondere Acryloyloxy-, Methacryloyloxy-, Sorboyloxy-, Cinnamoyloxy- oder 3-(2-Furyl)- acryloyloxygruppen, enthalten, und die im allgemeinen mit einem Photoinitiator der oben angegebenen Art eingesetzt werden, ist wohlbekannt. In der britischen Patentschrift Nr. 1 464 287 wird offenbart, dass sich der Zusatz eines Photoinitiators dadurch vermeiden lässt, dass man Chalkongruppen oder chalkonartige Gruppen in ein Molekül einer Verbindung mit einem solchen Rest einer olefinisch ungesättigten Monocarbonsäure einarbeitet.

In jüngster Zeit wurden photopolymerisierbare, photosensibilisierende Verbindungen beschrieben (U.S. Patentschrift Nr. 4 177 122), die man durch Anlagerung eines Alkylenoxyds an die phenolische(n) Hydroxylgruppe(n) eines hydroxylsubstituierten Benzophenons und anschliessende Veresterung mit einer ungesättigten Carbonsäure wie Acrylsäure oder Umsetzung mit Glycidylacrylat herstellt. Weitere solche Verbindungen wurden (siehe DE—OS 2 800 356) durch Umsetzung einer mehr als eine 1,2-Epoxidgruppe enthaltenden Verbindung mit einem stöchiometrischen Unterschuss Ammoniak und/oder eines aliphatischen oder cycloaliphatischen primären und/oder sekundären Amins, danach mit einem carboxylsubstituierten Benzophenon und schliesslich mit Acrylsäure oder Methacrylsäure hergestellt.

Es ist ebenfalls bekannt, dass olefinisch ungesättigte Verbindungen, z.B. solche, die Allylgruppen enthalten, an den Aethylendoppelbindungen eine durch aktinische Strahlung auslösbare Anlagerungsreaktion mit Polymercaptanen eingehen können (siehe z.B. Britische Patentschriften Nr. 1 215 591 und 1 445 814, die schon erwähnte britische Parentanmeldung Nr. 2 012 781 A sowie U.S. Patentschriften Nr. 3 615 450 und 4 220 513). Im allgemeinen muss man bei solchen Gemischen aus Polymercaptanen und olefinisch ungesättigten Verbindungen einen Photoinitiator einsetzen.

Es wurde nun gefunden, dass bei Einsatz von Verbindungen der Formel XXI als Komponente (a) die Mitverwendung eines Photoinitiators entfallen kann.

Spezielle Beispiele für Verbindungen der Formel XXI sind die Benzophenon-3,4,3',4'-tetracarbonsäure-X,X'-diallyl-Y-Y'-bis-(3-methacryloyloxy)-2-(2-carboxyäthoxycarbonyloxy)-propyl)-ester. (Die Bedeutung der Bezeichnungen X, X', Y und Y' ist weiter unten erklärt.)

Die in den Zusammensetzungen als Komponente (a) verwendeten Verbindungen sind neu und stellen somit ebenfalls einen Gegenstand der vorliegenden Erfindung dar.

Verbindungen der Formeln III bis XII, worin die $R^3$ jeweils Allyl oder Methally bedeuten, sind durch Ueberführung der entsprechenden Diallylphenole oder Dimethylallylphenole in ihre Glycidyläther, Oeffnung der Epoxidgruppen durch deren Umsetzung mit Acryl- oder Methacrylsäure und Veresterung der entstehenden sekundären alkoholischen Hydroxylgruppen mit dem Anhydrid einer Di- oder Polycarbonsäure erhältlich. Ebenfalls kann man diese durch die entsprechende Umsetzung der obengenannten Diallylphenole oder Dimethallylphenole mit Glycydilacrylat oder Glycidylmethacrylate und anschliessende Veresterung mit einem wie oben beschriebenen Anhydrid erhalten.

Verbindungen der Formel XIII, worin $R^3$ jeweils Allyl oder Methallyl bedeuten, lassen sich durch Ueberführung eines entsprechenden Phenol/Formaldehydnovolaks in seinen Tri- oder höheren Allyl- oder Methallyläther, Ueberführung dieser allyl- oder methallyl-substituierten Novolake in ihre Glycidyläther, Oeffnung der Epoxidgruppen durch deren Umsetzung mit Acryl- oder Methacrylsäure und Veresterung mit einem wie oben beschriebenen Anhydrid erhalten. Man kann sie auch durch Umsetzung der oben erwähnten allyl- oder methallyl-substituierten Novolake mit Glycidylacrylate oder Glycidylmethacrylat und anschliessende Veresterung mit einem wie oben beschriebenen Anhydrid herstellen.

Verbindungen der Formel XIV, worin mindestens zwei Gruppen $R^7$ je für Allyloxy oder Methallyloxy stehen, sind herstellbar durch Verätherung mindestens zweier phenolischer Hydroxylgruppen in einem Phenol/Formaldehydnovolak durch Umsetzung mit Allylchlorid oder Methallylchlorid, Ueberführung der verbleibenden phenolischen Hydroxylgruppe bzw. -gruppen in Glycidylgruppen, Umsetzung dieser Glycidylgruppen mit Acryl- oder Methacrylsäure und schliesslich Veresterung mit dem Anhydrid einer Di- oder Polycarbonsäure. Ferner kann man mindestens zwei phenolische Hydroxylgruppen mittels Allylchlorid oder Methallylchlorid veräthern, die verbleibende(n) Hydroxylgruppe bzw. -gruppen mit Glycidylacrylat oder-methacrylat reagieren lassen und die so gebildeten sekundären Hydroxylgruppen mit dem Anhydrid einer Di- oder Polycarbonsäure verestern.

Verbindungen der Formel XV und XVI, worin das bzw. die $R^2$ jeweils für eine Gruppe der Formel I und die $R^3$ je für Allyl oder Methallyl stehen, kann man dadurch erhalten, dass man die phenolische Hydroxylgruppe im Diallyl- odér Dimethallylphenol bzw. die beiden phenolischen Hydroxylgruppen im Tetraallyl- oder Tetramethallylbisphenol in eine Glycidyläthergruppe bzw. -gruppen überführt und anschliessend mit Acryl- oder Methacrylsäure und dann wie zuvor mit einem Anhydrid umsetzt. Ebenfalls kann man das Diallyl- oder Dimethallylphenol bzw. Tetraallyl- oder Tetramethallylbisphenol jenachdem mit einem bzw. zwei Mol Glycidylacrylat oder Glycidylmethacrylat reagieren lassen und dann wie zuvor beschrieben mit einem Anhydrid verestern.

Verbindungen der Formeln III bis XVI, worin die $R^3$ je für eine 1-Propenylgruppe stehen, können auf die gleiche Weise wie ihre Allylanalogen hergestellt werden, jedoch unter Einschluss einer Isomerisierungsstufe für die Allylgruppen durch Erhitzen mit Alkali vor der Veresterung am Schluss mit dem Anhydrid einer Di- oder Polycarbonsäure.

Die Bildung der Allyl- und Methallyläther einwertiger und mehrwertiger Phenole sowie deren Claisen-Umlagerung ist in der schon zitierten, bekanntgemachten britischen Patentanmeldung Nr. 2 012 781 A und in der U.S. Patentschrift Nr. 4 220 513 beschrieben, einschliesslich der Herstellung der 2,6-Diallylphenole, 2,6-Dimethallylphenole, 2,2',6,6'-Tetraallylbisphenol und 2,2',6,6'-Tetramethallylbisphenole sowie der

Umwandlung der Allylphenole in ihre Glycidyläther. Die Isomerisierung der Arylallyläther in Aryl-1-propenyläther ist ebenfalls in diesen Veröffentlichungen beschrieben.

Verbindungen der Formel XVIII kann man durch Veresterung einer Diglycidylverbindung der Formel

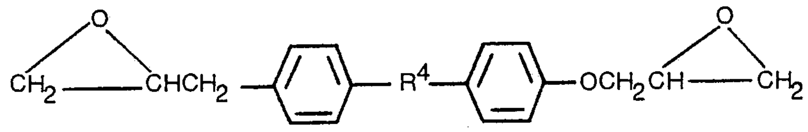 XXIX

mit Acryl- oder Methacrylsäure und weitere Veresterung an den neu gebildeten sekundären Hydroxylgruppen mit einem Endomethylentetrahydrophthalsäureanhydrid der Formel

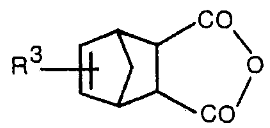 XXX

worin $R^3$ und $R^4$ die unter Formel III engegebenen Bedeutungen haben, herstellen.

Verbindungen der Formeln XIX und XX sind durch Umsetzung von Trimellithsäureanhydrid mit Allyl- oder Methallylalkohol und gegebenenfalls Isomerisierung der Allylgruppe zu einem Gemisch von Isomeren der Formel

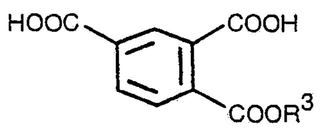 XXXI und 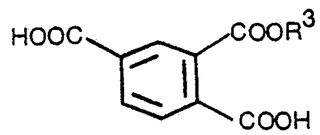 . XXXII

herstellbar.

Danach kann man die Verbindungen der Formel XXXI und XXXII in an sich bekannter Weise mit Glycidylacrylat oder Glycidylmethacrylat reagieren lassen und mit einem Di- oder Polycarbonsäureanhydrid verestern, was die Produkte der Formel XIX oder XX liefert, worin $R^2$ eine Gruppe der Formel I bedeutet. Dieselben Produkte lassen sich ebenfalls durch Ueberführung der Dicarbonsäuren der Formel XXXI oder XXXII in ihre Diglycidylester, Oeffnung der Epoxidgruppen in an sich bekannter Weise mit Acrylsäure oder Methacrylsäure und Veresterung wie zuvor erhalten.

Verbindungen der Formel XXI sind leicht aus handelsüblichem Benzophenon-3,4,3',4'-tetracarbonsäuredianhydrid herstellbar. So liefert Erhitzen dieses Dianhydrids mit Allylalkohol bzw. Methallylalkohol Benzophenon-3,4,3',4'-tetracarbonsäure-X-X'-diallylester bzw. die entsprechenden X,X'-Dimethallylester. Es wird angenommen, dass die Produkte die drei möglichen Isomeren enthalten, nämlich die 3,3'-Dicarboxy-4,4'-bis-(allyloxycarbonyl)-, 4,4'-Dicarboxy-3,3'-bis-(allyloxycarbonyl)- bzw. 3,4'-Dicarboxy-3',4-bis-(allyloxycarbonyl)derivate des Benzophenons sowie bei Verwendung von Methallylalkohol deren Methallylhomologe. Die Nützlichkeit dieser Erfindung ist jedoch nicht von de Richtigkeit dieser Annahme abhängig.

Umsetzung dieser Diester-dicarbonsäuren mit Epichlorhydrin und nachfolgende Dehydrochlorierung in zur Herstellung von Glycidylestern aus Carbonsäuren bekannter Weise liefert Benzophenon-3,4-3',4'-Tetracarbonsäure-X,X'-diallyl-Y,Y'-diglycidylester und die entsprechenden Methallylverbindungen. Reaktion dieser Diallyl-diglycidylester mit Acrylsäure bzw. Methacrylsäure ergibt die X,X'-Diallyl-Y,Y'-bis-(3-(acryloyloxy)-2-hydroxypropyl)-tetraester bzw. die entsprechenden Methacryloylhomologen, d.h. die Verbindungen der Formel XXI, woring eines von $R^9$ und $R^{10}$ bzw. $R^{11}$ und $R^{12}$ jeweils für eine Allylgruppe steht und die verbleibenden Symbole $R^9$ und $R^{10}$ bzw. $R^{11}$ und $R^{12}$ jeweils eine Gruppe der Formel XXII bedeuten. Diese Tetraester sind auch durch Umsetzung der 3,4,3',4'-Tetracarbonsäure-X,X'-diallylester mit 2 Molanteilen Glycidylacrylat oder Glycidylmethacrylat erhältlich. Die Methallylhomologen kann man in ähnlicher Weise herstellen. Veresterung mit dem Anhydrid einer Di-oder Polycarbonsäure führt zu den gewünschten Produkten.

Verbindungen der Formel XVII können durch Umsetzung eines in 5-Stellung durch $R^8$ substituierten 1,3-Diglycidylhydantoins mit Acryl- oder Methacrylsäure und Veresterung der so entstandenen sekundären Hydroxylgruppen mit einem Anhydrid der Formel

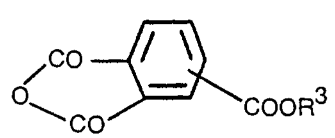 XXXIII

worin $R^3$ die unter Formel III angegebene Bedeutung hat, oder durch Umsetzung eines so substituierten Hydantoins mit Glycidylacrylat oder Glycidylmethacrylat und Veresterung mit einem Anhydrid der Formel XXXIII hergestellt werden.

Die Anhydride der Formel XXXIII werden ihrerseits durch Umsetzung von Trimellithsäureanhydrid mit Thionylchlorid zum Säurechlorid-anhydrid und dessen Reaktion mit einem Alcohol $R^3OH$ hergestellt.

Verbindungen der Formel XXIII sind herstellbar durch Veresterung einer Diglycidylverbindung der Formel

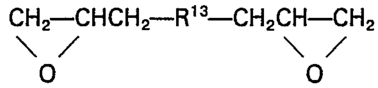

XXXIV

mit Acryl- oder Methacrylsäure und weitere Veresterung der entstandenen sekundären Hydroxylgruppen mit einem Anhydrid der Formel

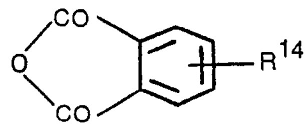

XXXV

woring $R^{13}$ und $R^{14}$ die unter Formel XXIII angegebenen Bedeutungen haben, oder durch Umsetzung des Phenols bzw. Hydantoins $H—R^{13}—H$ mit Glycidylacrylat oder Glycidylmethylacrylat und Veresterung mit einem Anhydrid der Formel XXXV.

Eine grosse Anzahl Polymercaptane ist zur Verwendung als Komponente (b) in den erfindungsgemässen Zusammensetzungen geeignet. Vorzugsweise sind die Mercaptane frei von jeglichen Allyl-, Methallyl-, 1-Propenyl-, Acryloyl- oder Methacryloylgruppen, und sie weisen bevorzugt ein Molekülargewicht von höchstens 3 000 auf. Die dabei eingesetzten Polymercaptane enthalten üblicherweise nicht mehr al sechs direkt an aliphatische Kohlenstoffatome gebundene Mercaptangruppen pro Molekül. Vorzugsweise enthalten sie jedoch mehr al zwei solche Mercaptangruppen.

Eie Klasse umfasst Ester von Monomercaptanalkylencarbonsäuren mit mehrwertigen Alkoholen bzw. einwertigen aliphatischen Monomercaptanalkoholen mit Polycarbonsäuren.

Weitere bevorzugte Ester sind solche der Formel

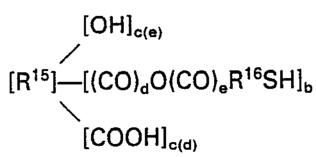

XXXVI

worin $R^{15}$ einen gegebenenfalls in der Kette durch nicht mehr als ein Aethersauerstoffatom unterbrochenen aliphatischen oder araliphatischen Kohlenwasserstoffrest mit 2 bis 60 Kohlenstoffatomen und $R^{16}$ einen gegebenenfalls in der Kette durch nicht mehr als eine Carbonyloxygruppe unterbrochenen aliphatischen Kohlenwasserstoffrest mit vorzugsweise 1 bis 4 Kohlenstoffatomen bedeuten sowie b eine ganze Zahl von 2 bis 6, vorzugsweise 3 bis 6, c null oder eine positive ganze Zahl von höchstens 3, so dass (b + c) höchstens 6 ist (wobei Grössen wei c(d) algebraisch auszulegen sind), sowie d und e je null oder 1 aber nicht gleich sind.

Weitere bevorzugte Ester sind auch Polymercaptane der Formel XXXVI, die ferner der Formel

$$R^{17}(OCOR^{18}SH)_b \qquad \text{XXXVII}$$

entsprechen, worin b die unter Formel XXXVI angegebene Bedeutung hat und $R^{17}$ einen aliphatischen Kohlenwasserstoffrest mit 2 bis 10 Kohlenstoffatomen und $R^{18}$ $—(CH_2)—$, $—(CH_2)_2$- oder $—CH(CH_3)$- darstellen.

Eine zweite Klasse umfasst mercaptanhaltige Ester, einschliesslich Ester von Monomercaptandicarbonsäuren der Formel

$$R^{21}{+}(O)_d—CO(O)_e—R^{19}(O)_e—CO(O)_d—R^{20}SH]_f \qquad \text{XXXVIII}$$

worin d und e die unter Formel XXXVI angegebenen Bedeutungen haben, f eine ganze Zahl von 1 bis 6, vorzugsweise von 2 bis 6, ist, $R^{19}$ für einen über eines bzw. mehrere seiner Kohlenstoffatome an die angegebenen —O— oder —CO— Einheiten gebundenen zweiwertigen organischen Rest, $R^{20}$ für einen über eines bzw. mehrer seiner Kohlenstoffatome an die angegebene —SH—Gruppe und —O— oder —CO—Einheit gebundenen zweiwertigen organischen Rest und $R^{21}$ für einen über eines bzw. mehrere seiner Kohlenstoffatome an die angegebene(n) danebenliegende(n) —O— oder —CO—Einheit bzw. -Einheiten gebundenen organischen Rest, der bei f = 1 mindestens eine aliphatische —SH—Gruppe enthalten muss bzw. bei f = 2 vorzugsweise mindestens eine solche Gruppe enthält, stehen.

Ist d null, so bedeutet $R^{19}$ vorzugsweise eine gesättigte aliphatische unverzweigte, gegebenenfalls durch eine oder mehrere Methylgruppen und eine oder mehrere Mercaptangruppen substituierte und gegebenenfalls durch eine oder mehrere Aethersauerstoffatome und eine oder mehrere Carbonyloxygruppen unterbrochene Kohlenwasserstoffkette mit 2 bis 20 Kohlenstoffatomen. Mit d = 1 bedeutet $R^{19}$ vorzugweise (i) eine gesättigte aliphatische, gegebenenfalls eine Mercaptangruppe tragende Kohlenwasserstoffgruppe mit 2 bis 10 Kohlenstoffatomen, (ii) eine gegebenenfalls eine oder mehrere Aethylendoppelbindungen enthaltende, cycloaliphatisch-aliphatische Kohlenwasserstoffgruppe mit 5 bis 34 Kohlenstoffatomen oder (iii) eine einkernige Arylenkohlenwasserstoffgruppe mit 6 bis 12 Kohlenstoffatomen.

Bei d = null bedeutet $R^{20}$ vorzugsweise eine gesätigte aliphatische, gegebenenfalls eine Carboxylgruppe tragende aliphatische Kohlenwasserstoffgruppe mit 1 bis 3 Kohlenstoffatomen und bei d = 1 vorzugsweise eine gesättigte aliphatische, gegebenenfalls durch eine Hydroxylgruppe oder ein Chloratom substituierte Kohlenwasserstoffgruppe mit 2 bis 4 Kohlenstoffatomen.

$R^{21}$ steht vorzugsweise für (iv) eine gegebenenfalls mindestens eine aliphatische Mercaptangruppe tragende, aliphatische oder cycloaliphatisch-aliphatische Kohlenwasserstoffgruppe mit 2 bis 51 Kohlenstoffatomen, (v) eine einkernige oder zweikernige Arylenkohlenwasserstoffgruppe mit 6 bis 15 Kohlenwasserstoffatomen, (vi) eine durch mindestens ein Aethersauerstoffatom unterbrochene und gegebenenfalls durch mindestens eine aliphatische Mercaptangruppe substituierte Kette mit 4 bis 20 Kohlenstoffatomen oder (vii) eine durch mindestens eine Carbonyloxygruppe und gegebenenfalls durch mindestens ein Aethersauerstoffatom unterbrochene sowie gegebenenfalls durch mindestens eine aliphatische Mercaptangruppe substituierte Kette mit 6 bis 50 Kohlenstoffatomen.

Eine dritte Klasse umfasst Ester and Aether, die der allgemeinen Formel.

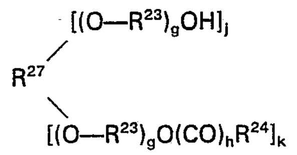

XXXIX

entsprechen, worin $R^{22}$ für den Rest eines mehrwertigen Alkohols nach Entfernung von (j + k) alkoholischen Hydroxylgruppen, insbesondere einen aliphatischen Kohlenwasserstoffrest mit 2 bis 10 Kohlenstoffatomen, $R^{23}$ jeweils für eine Alkylengruppe mit einer Kette von mindestens 2 und höchstens 6 Kohlenstoffatomen zwischen den abgebildeten aufeinanderfolgenden Sauerstoffatomen und $R^{24}$ für einen mindestens eine Mercaptangruppe enthaltenden aliphatischen Rest mit 1 bis 6 Kohlenstoffatomen stehen, g eine positive ganze Zahl, derart dass das Durchschnittsmolekulargewicht des Polymercaptans vorzugsweise 2 000 nicht übersteigt, h null oder 1, j null oder eine positive ganze Zahl, derart dass (j + k) höchstens 6 ist, und k eine ganze Zahl von 2 bis 6, vorzugsweise von 3 bis 6, sind.

Die Gruppen $R^{23}$ in einzelnen Poly-(oxyalkylen)-ketten können gleich oder verschieden und durch z.B. Phenyl- oder Chlormethylgruppen substituiert sein. Vorzugsweise sind dies $—C_2H_4—$ oder $—C_3H_6—$Gruppen.

Unter den Verbindungen der Formel XXXIX werden die Ester der Formel

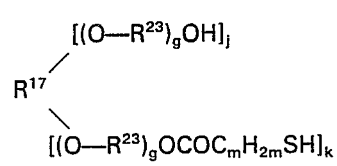

XL

und Aether der Formel

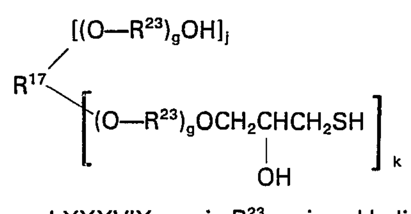

XLI

bevorzugt, worin $R^{17}$ die unter Formel XXXVIX sowie $R^{23}$, g, j und k die unter Formel XXXXIX angegebenen Bedeutungen haben und m 1 oder 2 ist.

Eine vierte Klasse von als Komponente (b) geeigneten Polymercaptanen umfasst Sulfide mit Mercaptanendgruppen, der allgemeinen Formel

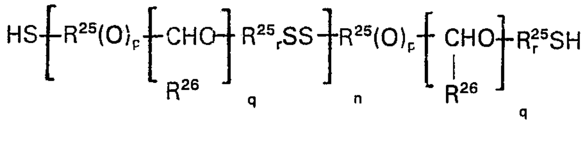

XLII

worin $R^{25}$ jeweils eine Alkylenkohlenwasserstoffgruppe mit 2 bis 4 Kohlenstoffatomen und $R^{26}$ ein Wasserstoffatom oder eine Methyl- oder Aethylgruppe darstellen, n eine ganze Zahl mit einem Durchschnittswert von mindestens 1 und vorzugweise einer solchen Grösse, dass das Durchschnittsmolekulargewicht des Sulfids höchstens 1 000 ist, und entweder p null, in welchem Fall q und r dann ebenfalls null sind, oder p 1, in welchem Fall q null oder 1 und r 1 sind, bedeuten.

Eine fünfte Klasse als Komponente (b) geeigneter Polymercaptane umfasst Polybutadiene mit Mercaptanendgruppen, der allgemeinen Formel

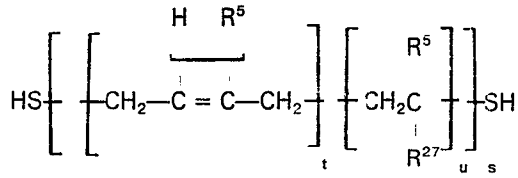

XLIII

worin $R^5$ jeweils die unter Formel III angegebene Bedeutung hat, $R^{27}$ für $—CN$, $—COOH$, $—CONH_2$, $—COOR^{28}$, $—C_6H_5$ oder $—OCOR^{28}$ steht, wobei $R^{28}$ eine Alkylgruppe mit eins bis acht Kohlenstoffatomen darstellt, sowie t eine ganze Zahl von mindestens 1, u null oder eine positive ganze Zahl und s eine ganze Zahl grösser als eins sind, vorzugsweise derart, dass das Molekulargewicht des Polymercaptans im Zahlenmittel 1 000 nicht übersteigt.

Eine sechste Klasse von Polymercaptanen zur Verwendung als Komponente (b) umfasst Oxyalkylenverbindungen mit Mercaptanendgruppen, der allgemeinen Formel

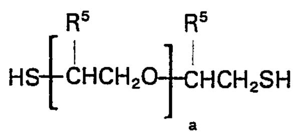

XLIV

worin $R^5$ jeweils die unter Formel III und a die unter Formel XIII angegebenen Bedeutungen haben.

Die Substanzen der Formeln XLII bis XLIV fallen nicht in den bevorzugten Bereich, da sie Dimercaptane sind.

Eine siebente Klasse umfasst Polythioglykolate und Polymercaptopropionate von Tris-(2-hydroxyäthyl)-isocyanurat, Tris-(2-hydroxypropyl)-isocyanurat, N,N'-Bis-(2-hydroxyäthyl)-hydantoinen und N,N'-Bis-(2-hydroxypropyl)-hydantoinen, d.g. die Verbindungen der Formel

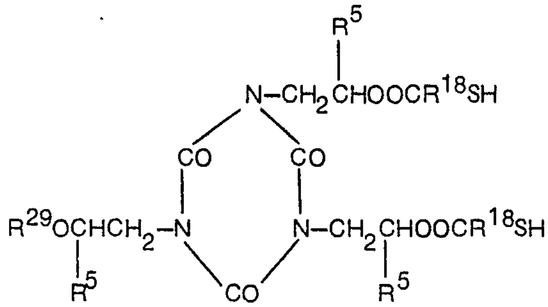

XLV

oder

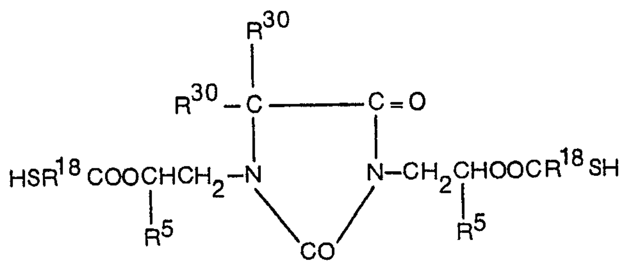

XLVI

worin $R^5$ jeweils die unter Formel III und $R^{18}$ jeweils die unter Formel XXXVII angegebenen Bedeutungen haben, $R^{29}$ für eine Gruppe $—OCR^{18}SH$ oder ein Wasserstoffatom steht und $R^{30}$ jeweils eine Alkylgruppe mit 1 bis 8 Kohlenstoffatomen, insbesondere eine Methyl- oder Aethylgruppe, eine Aralkylgruppe mit 7 bis 9 Kohlenstoffatomen oder eine Arylgruppe mit 6 bis 8 Kohlenstoffatomen bedeutet oder die beiden $R^{30}$ zusammen mit dem daran gebundenen Kohlenstoffatom einen Cyclopentan- oder Cyclohexanring bilden.

Spezielle Beispiele für geeignete Polymercaptane sind Pentaerythrit-tetrathioglykolat, Dipentaerythrithexakis-(3-mercaptopropionat), Trimethylolpropan-trithioglykolat sowie ein Tris-(3-mercapto-2-hydroxypropyläther) eines Polyoxypropylentriols vom Durchschnittsmolekulargewicht 800.

Bei der Photopolymerisation der erfindungsgemässen Zusammensetzungen verwendet man vorzugsweise aktinische Strahlung von 200—600 nm Wellenlänge. Als aktinische Strahlungsquellen eignen sich unter anderem Kohlelichtbögen, Quecksilberdampflichtbögen, Leuchtröhren mit ultraviolettes Licht aussendenden Leuchtstoffen, Argon- und Xenonglimmlampen, Wolframlampen sowie photographische Flutlampen. Dabei sind Quecksilberdampflichtbögen, insbesondere Höhensonnen und fluoreszierende Höhensonnen, sowie Metallhalogenidlampen am besten geeignet. Die zur Belichtung der photopolymerisierbaren Zusammensetzung erforderliche Zeit hängt von verschiedenen Faktoren ab, unter anderem beispielsweise den verwendeten einzelnen Verbindungen, der Art der Lichtquelle und deren Abstand von der bestrahlten Zusammensetzung. Der Fachmann in Photopolymerisationstechnik kann leicht die geeigneten Zeiten bestimmen. Zur Photopolymerisation sollen die Zusammensetzungen (ausser den eine Verbindung der Formel XXI enthaltenden) einen zugsetzten Photoinitiator enthalten, d.h. einen Katalysator, der bei Bestrahlung einen angeregten Zustand ergibt, der zur Bildung freier Radikale führt, die dann die Polymerisation der Zusammensetzung einleiten. Beispiele für geeignete Photoinitiatoren sind organische Peroxyde und Hydroperoxyde, α-halogensubstituierte Acetophenone wie Trichlormethyl-4'-tert.-butylphenylketon, α-hydroxy-α-alkylsubstituierte Acetophenone wie 2-Hydroxy-2-methyl-1-phenylpropanon-1, Benzoin und dessen Alkyläther (z.B. der n-Butyläther), α-Methylbenzoin, Benzophenone wie Benzophenon selbst und 4,4'-Bis-(dimethylamino)-benzophenon, O-Alkoxycarbonylderivate eines Oxims des Benzils oder 1-Phenylpropan-1,2-dions, wie Benzil-(O-äthoxycarbonyl)-α-monoxim und 1-Phenylpropan-1,2-dion-2-(O-äthoxycarbonyl)-oxim, Benzilketale, z.B. dessen Dimethylketal, substituierte Thioxanthone, z.B. 2-Chlorthioxanthon, Anthrachinone und Photoredoxsysteme, die aus einem Gemisch eines Phenothiazinfarbstoffs (z.B. Methylenblau) oder eines Chinoxalins (z.B. einem Metallsalz der 2-(m- oder p-Methoxyphenyl)-chinoxalin-6'- oder -7'-sulfonsäure) mit einem Elektronendonator wie Benzolsulfinsäure oder einer anderen Sulfinsäure oder einem Salz davon, wie dem Natriumsalz, oder einem Arsin, einem Phosphin oder Thioharnstoff bestehen.

Geeignete Photoinitiatoren lassen sich leicht durch Serienversuche auffinden. Im allgemeinen werden 0,05 bis 10 Gew.-% und vorzugsweise 0,5 bis 5 Gew.-% Photoinitiator eingearbeitet, bezogen auf das kombinierte Gewicht der Komponenten (a) und (b).

Der Begriff "Radikalkatalysator" wie hieren angewandt bezieht sich auf Substanzen, und aktinische Strahlung ist dabei nicht eingeschlossen. Zur Polymerisation der erfindungsgemässen Zusammensetzungen geeignete Radikalkatalysatoren sind hitzeaktivierbar, d.h. sie üben eine Polymerisationswirkung mit beträchtlicher Geschwindigkeit nur bei Temperaturen oberhalb der normallen Umgebungstemperatur aus; dazu gehören 2,2'-Azobis-(2-methylpropionitril) und organische oder anorganische Peroxyde, z.B. Persäuren und deren Salze und Ester, wie Peressigsäure, Perbenzoesäure, Perphthalsäure, Diisopropylperoxydicarbonat, Ammonium- oder ein Alkaliperborat, Ammonium- oder ein Alkalipersulfat, Acylperoxyde wie Benzoylperoxyd sowie z.B. Cumylperoxyd, Cumolhydroperoxyd, Wassterstoffperoxyd, Cyclohexanonperoxyd und Aethylmethylketonperoxyd. Dabei kann man mit den Peroxyden ein tertiäres Amin, z.B. Dimethylanilin, oder ein Kobaltsikkativ, z.B. Kobaltnaphthenat, als Beschleuniger verwenden.

Die Menge Radikalkatalysator, gegebenenfalls mit dem Beschleuniger dafür, beträgt üblicherweise 0,05 bis 5 und vorzugsweise 0,1 bis 1 Gew.-%, berechnet auf das Gesamtgewicht der Komponenten (a) und (b). Dabei können die herkömmlichen Methoden zur radikalkatalysierten Polymerisation angewendet werden.

Wie schon erwähnt sind die erfindungsgemässen Zusammensetzungen als Oberflächenbeschichtungen verwendbar. Dabei kann man sie vorzugsweise in flüssiger Form auf ein Substrat wie Stahl, Aluminium, Kupfer, Chrom, Cadmium, Zink, Zinn, Glas, Keramik, Papier oder Holz aufbringen und photopolymerisieren oder mittels eines Radikalkatalysators polymerisieren lassen. Nach Photopolymerisation eines Teils der Beschichtung durch aktinische Bestrahlung können die unbelichteten und unpolymerisierten Abschnitte durch Waschen mit einer verdünnten wässrig-alkalischen Lösung entfernt werden, während die photopolymerisierten Teile an Ort und Stelle verbleiben.

Die erfindungsgemässen Zusammensetzungen sind somit bei der Herstellung von Druckplatten und gedruckten Schaltungen verwendbar. Herstellungsmethoden für Druckplatten und gedruckte Schaltungen aus photopolymerisierbaren Zusammensetzungen sind wohlbekannt.

Bei der Herstellung mehrschichtiger gedruckter Schaltungen wird ein metallisches Substrat mit einer photopolymerisierbaren Zusammensetzung beschichtet und dann durch ein Negativ hindurch mit Strahlung belichtet. Danach kann dann eine Reihe von Beschichtungs- und Aetzstufen erfolgen, während deren die polymerisierte Beschichtung entfernt werden muss. Dies erfolgt normalerweise mechanisch, aber es wurde nun gefunden, dass man bei Verwendung einer erfindungsgemässen Zusammensetzung das photopolymerisierte Material ohne Beschädigung der geätzten Metalloberfläche durch Behandlung mit einer wässrig-alkalischen Lösung unter schärferen Bedingungen als beim ursprünglichen Entwickeln völlig entfernen kann. Durch eine solche Behandlung wird das unter der photopolymerisierten Schicht liegende Metall freigelegt, ohne dass irgend eine mechanische Behandlung nötig wäre.

Die zum Entwickeln der Abbildung verwendeten alkalischen Lösungen sind vorzugsweise 0,5 vis 5 %iges wässriges Natrium- oder Kaliumcarbonat; zur Entfernung des photopolymerisierten Harzes verwendent man vorzugsweise 3 bis 10 %ige Natron- oder Kalilauge, wobei sich all diese Prozentangaben auf das Gewicht beziehen.

Gegenstand dieser Erfindung sind dementsprechend die aus den erfindungsgemässen Zusammensetzungen hergestellten Druckplatten oder gedruckte Schaltungen.

Die erfindungsgemässen Zusammensetzungen sind auch als Klebstoffe verwendbar, wobei man Strahlung oder einen Radikalkatalysator dazu einsetzt, die Polymerisation einer zwischen den Flächen eingeschlossenen Schicht der Zusammensetzung einzuleiten, wobei man die in der schon erwähnten U.S. Patentschrift Nr. 4 220 513 beschriebenen Methoden anwendet, auf deren Offenbarungen hiermit ausdrücklich Bezug genommen wird.

Gegenstand dieser Erfindung sind dementsprechend Artikel mit durch ein nach dem erfindungsgemässen Verfahren hergestelltes polymerisiertes Produkt verklebten Oberflächen.

Die Zusammensetzungen sind auch bei der Herstellung von faserverstärkten Verbundstoffen, einschliesslich Plattenformmassen, und als Tauchlackierungszusammensetzungen gemäss der in der oben erwähnten U.S. Patentschrift Nr. 4 220 513 beschriebenen Arbeitsweise verwendbar.

Ferner wurde gefunden, dass es möglich ist, die erfindungsgemässen Zusammensetzungen in zwei Stufen zu härten: eine solche, einen hitzeaktivierbaren Radikalkatalysator sowie gegebenenfalls einen Photoinitiator enthaltende Zusammensetzung lässt sich durch Belichtung mit einer zur vollständigen Polymerisation ungenügenden Menge aktinischer Strahlung teilweise polymerisieren und wird dann erhitzt, so dass der Radikalkatalysator aktiviert wird und Aushärtung bewirkt.

Weitere Gegenstände dieser Erfindung sind demnach eine Zusammensetzung, die eine Komponente (a) und eine Komponente (b) wie oben angegeben, gegebenenfalls einen Photoinitiator sowie einen hitzeaktivierbaren Radikalkatalysator enthält, und ein Verfahren zum Härten einer solchen Zusammensetzung, welches darin besteht, dass man diese durch Belichtung mit aktinischer Strahlung teilweise polymerisiert und sie dann erhitzt, um den hitzeaktivierbaren Radikalkatalysator zu aktivieren.

Solche Zusammensetzungen sind zur Bildung von Filmklebern und Verbundstoffen, bei der Tauchlackierung und bei der Herstellung von Plattenformmassen, wie in der zitierten U.S. Patentscrift Nr. 4 220 513 beschrieben, verwendbar.

Erfindungsgemässe Zusammensetzungen können in zwei Komponentpackungen in den Handel gebracht werden, wobei ein Teil die Komponente (a) und der andere die Komponente (b) enthält. Andernfalls kann man sie unter Schutz vor aktinischer Strahlung und Radikalquellen als Gemische bis zum Gebrauch lagern.

Die nachfolgenden Beispiele erläutern die Erfindung. Prozentangaben beziehen sich auf das Gewicht.

Das als Ausgangsmaterial verwendete 2,2-Bis-(3-allyl-4-(glycidyloxy)-phenyl)-propan wird wie folgt hergestellt: 2,2-Bis-(3-allyl-4-hydroxyphenyl)-propan bereitet man gemäss der oben erwähnten U.S. Patentschrift Nr. 4 220 513. Dieses Produkt (308,0 g) mischt man mit 2-Methoxyäthanol (10,0 g) und Epichlorhydrin (740,0 g) und erhitzt auf 60°C. Natriumhydroxyd in Flockenform (80,0 g) wird in Portionen im Verlauf von 3 Stunden dazugegeben und das Gemisch noch eine ½ Stünde ebenfalls bei 60°C gerührt.

Man filtriert, wäscht den Rückstand mit Toluol und dampft das Filtrat zur Entfernung der Lösungsmittel und des überschüssigen Epichlorhydrins ein. Das eingeengte Produkt wird nochmals filtriert und liefert 334 g 2,2-Bis-(3-allyl-4-(glycidyloxy)-phenyl)propan mit einem Epoxidgehalt von 4,03 val/kg und 4,5 Allyldoppelbindungsäquivalenten/kg.

## Beispiel 1

Man vermischt 2,2-Bis-(3-allyl-4-glycidyloxy)-phenyl)-propan (100 g) und 2,6-Di-tert.-butyl-p-kresol (0,2 g) und erhitzt auf 100°C. Dann versetzst man im Verlauf 1 Stunde mit einem Gemisch aus Methacrylsäure (40 g), 5%iger Chromoctanoatlösung in Petroläther (0,1 g) und 2,6-Di-tert.-butyl-p-kresol (0,4 g).

Man erhitzt 6 Stunden auf 100°C und versetzt dann tropfenweise im Verlauf von 15 Minuten mit einem Gemisch aus Methacrylsäure (4,76 g) und 2,6-Di-tert.-butyl-p-kresol (0,09 g). Man erhitzt noch weitere 4 Stunden auf 100°C, worauf eine Probe genommen und aud Epoxidgehalt geprüft wird, der sich als null erweist.

Im Verlauf 1 Stunde versetzt man mit Bernsteinsäureanhydrid (39,5 g). Man rührt noch 3¼ Stunden bei 100°C und kühlt dann ab, was 185 g einer viskosen, dunkelgelben Flüssigkeit als hauptsächlich aus 2,2-Bis-(3-allyl-4-(3-(methacryloyloxy)-2-(2-carboxyäthylcarbonyloxy)-propoxy)-phenyl)-propan bestehendes Produkt liefert.

Dann gibt man Pentaerythrit-tetrathioglykolat (50 g, d.h. 1 Mercaptangruppenäquivalent pro Allylgruppenäquivalent) dazu und rührt bis zur Homogenität, was Gemisch A liefert.

Man gibt Benzildimethylketal (0,15 g) zu Gemisch A (5 g) und bringt die Zusammensetzung als Ueberzug auf ein kupferkaschiertes Laminat auf, wobei ein etwa 20 µm dicker klebriger Film verbliebt. Diese Film wird 15 Minuten ein 1 mm über dem Film angebrachtes Negativ hindurch mit einer 500 W Mitteldruckquecksilberbogenlampe im Abstand von 22 cm bestrahlt. Nach der Bestrahlung wird die Abbildung durch Eintauchen des Laminats in 1%ige wässrige Natriumcarbonatlössung bei Raumtemperatur entwickelt. Die unbelichteten Stellen werden weggewaschen, wobei eine gute Reliefabbildung auf dem Kupfer verbleibt. Die unbeschichten Kupferstellen können dann mit einer wässrigen Ferrichloridlösung (41 % $FeCl_3$) bei 35°C geätzt werden, wobei die beschichteten Stellen intakt bleiben. Die Beschichtung auf diesen Stellen lässt sich durch Behandlung mit 50%iger Natronlauge bei Raumtemperatur entfernen.

Beispiel 2

Ein kupferkaschiertes Laminat wird wie in Beispiel 1 beschrieben mit Gemisch A und Benzildimethylketal beschichnet und dann durch eine von Primarc Ltd. (Stoke Row, bei Henley-on-Thames, Oxfordshire, England) gelieferten "Mini-arc"-Apparat geführt, der zei Mitteldruckquecksilberbogenlampen von 80 W pro cm Nennleistung enthält und mit einter Bandgeschwindigkeit von 50 m pro Minute läuft. Bei dieser Behandlung wird die Beschichtung klebfrei, bleibt jedoch noch photopolymerisierbar.

Ein Negativ wird im Kontakt auf die Beschichtung gelgt und 15 Minuten wie in Beispiel 1 beschrieben bestrahlt. Entwicklung in 2%iger wässriger Natronlauge ergibt ein klares Reliefbild auf dem Laminat, das dann gemäss Beispiel 1 geätzt werden kann.

Beispiel 3

Man bringt Gemisch A (10 g), vermischt mit Glycidylmethacrylat (1 g) und Benzildimethylketal (0,3 g) als 10 µm dicke Beschichtung auf Weissblech auf. 5 Sekunden Belichtung mit der Strahlung einer 80 W pro cm Quecksilberbogenlampe im Abstand von 8 cm ergibt eine Beschichtung; die 20-maligem Reiben mit einem in Aceton getränkten Wattebausch widersteht.

Beispiel 4

Man erhitzt ein Gemisch aus Trimellithsäureanhydrid (57,6 g, aus Essigsäureanhydrid umkristallisiert) und Allylalkohol (175 g) 4½ Stunden unter Rückfluss und destilliert dann den überschüssigen Allylalkohol bei vermindertem Druck ab, wobei 74,5 g der Monoallylester von Benzol-1,2,4-tricarbonsäure als weisser Feststoff zurückbleiben.

Das so erhaltene Gemisch aus Allyl-2,4-dicarboxybenzoat und Allyl-2,5-dicarboxybenzoat (50 g) wird in Gegenwart von 0,17 g Trimethylammoniumchlorid und 0,2 g 2,6-Di-tert.-butyl-p-kresol 12 Stunden bei 60°C mit 57 g Glycidylmetacrylat (2 Moläquivalente) erhitzt, was ein Gemisch aus 1-(Allyloxycarbonyl)-2,4- und -2,5-bis-(3-methacryloyloxy)-2-hydroxypropoxycarbonyl)-benzol, d.h. der Verbindungender Formeln

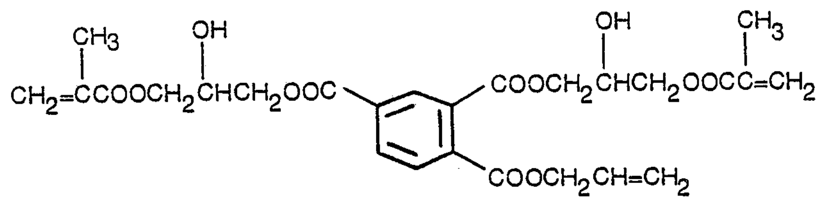

XLVII

und

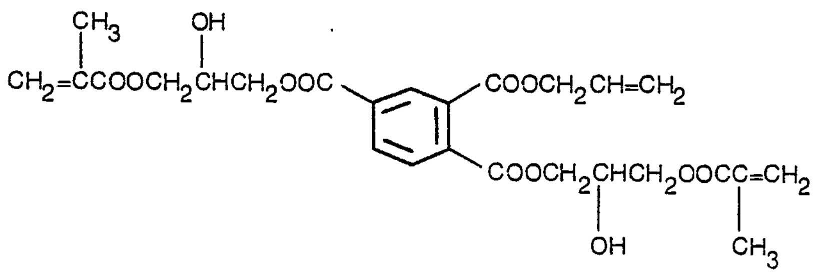

XLVIII

ergibt.

Dieses Produkt (50 g) wird gemäss Beispiel 1 mit Bernsteinsäureanhydrid (15 g) verestert. Das entstandene, vorwiegend aus 1 - (Allyloxycarbonyl) - 2,4 - bis - (3 - (methyacryloyloxy) - 2 - (2 - carboxyäthylcarbonyloxy) - propoxycarbonyl) - benzol und 1 - (Allyloxycarbonyl) - 2,5 - bis - (3 - (methacryloyloxy) - 2 - (2 - carboxyäthylcarbonyloxy) - propoxycarbonyl) - benzol bestehende Gemisch kann dann mit Pentaerythrit - tetrathio - glykolat in einer Menge von 1 Mercaptangruppenäquivalent pro Allylgruppenäquivalent vermischt und gemäss Beispiel 1 photopolymerisiert werden.

Beispiel 5

Man stellt wie zuvor aus 64 g Trimellithsäureanhydrid ein Gemisch der Monoallylester der Benzol-1,2,4 - tricarbonsäure her, erhitzt dieses in Gegenwart einer 5%igen Chromoctanoatlösung in Petroläther (0,13 g) und 2,6 - Di - tert. - butyl - p - kresol (0,26 g) auf 80°C und versetzt dann tropfenweise im Verlauf von 45 Minuten mit 47,4 g Glycidylmethacrylat (d.h. 1 Moläquivalent). Man rührt noch weitere 6 Stunden bei 80°C, nach welcher Zeit der Epoxidgehalt vernachlässigbar klein ist.

Das Produkt besteht aus Allyl - 2 - (3 - (methacryloyloxy) - 2 - hydroxypropoxycarbonyl) - 4-carboxybenzoat und Allyl - 2 - carboxy - 4 - (3 - (methacryloyloxy) - 2 - hydroxypropoxycarbonyl)-benzoat zusammen mit Allyl - 2,4 - dicarboxybenzoat und Allyl - 2,4 - bis - (3 - (methacryloyloxy) - 2-hydroxypropoxycarbonyl) - benzoat sowie den entsprechenden, sich von Allyl - 2,5 - dicarboxybenzoat ableitenden Isomeren.

Das durchschnittlich 1 Carboxylgruppe, 1 über eine Oxycarbonylgruppe an ein aromatisches Kohlenstoffatom gebundene Allylgruppe und 1 Methacryloyloxygruppe pro Molekül enthaltende Produkt

(3,91 g) wird mit 1,11 g Aethylenglykoldithioglykolat (d.h. 1 Mercaptangruppenäquivalent pro Allygruppenäquivalent) und 0,15 g Benzildimethylketal vermischt, als 10 µm dicke Beschichtung auf ein kupferkaschiertes Laminat aufgebracht und 1-2 Sekunden im Abstand von 22 cm mit einer Lampe von 80 W pro cm Nennleistung bestrahlt, wobei es Klebfrei wird. Bei 20 Minuten langer Bestrahlung durch ein Negativ hindurch mir einer Lampe von 30 W pro cm Nennleistung im Abstand von 20 cm und nachfolgendem Entwickeln durch Bürsten mit 1%iger wässriger Natriumcarbonatlösung erhält man eine negative Abbildung.

Beispiel 6

Man verfährt wie in Beispiel 5, jedoch unter Verwendung von 1,14 g Pentaerythrittetrathioglykolat (d.h. 1 Mercaptangruppenäquivalent pro Allylgruppenäquivalent). Beim Entwickeln erhält man eine gute negative Abbildung.

Beispiel 7

Man erhitzt ein Gemisch aus 2,2 - Bis - (3 - (1 - propenyl) - 4 - glycidyloxy) - phenyl) - propan (49,2 g), Tetramethylammoniumchlorid (0,1 g) und Hydrochinon (0,15 g) auf 80°C, versetzt dann im Verlauf von 1,5 Stunden tropfenweise mit Mathacrylsäure (20,4 g) und rührt weitere 8 Stunden bei 80°C, was 2,2- Bis - (3 - (1 - propenyl) - 4 - (3 - (methacryloyloxy) - 2 - hydroxypropoxy) - phenyl) - propan, d.h. die Verbindung der Formel.

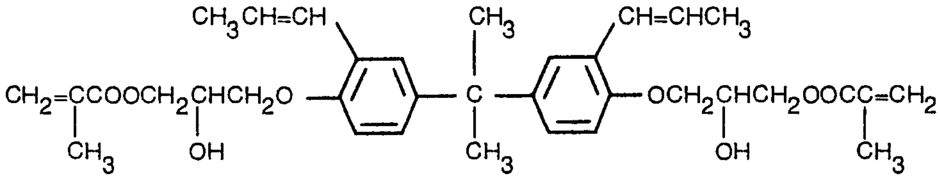

IL

liefert.

Diese Verbindung (50 g) verestert man gemäss Beispiel 1 mit Bernsteinsäureanhydrid (13,5 g). Ein Gemisch des so gebildeten Esters, d.h. 2,3 - Bis - (3 - (1 - propenyl) - 4 - (3 - (methyacryloyloxy) - 2- (2 - carboxyäthylcarbonyloxy) - propoxy) - phenyl) - propan mit Pentaerythrit - tetrathioglykolat (1 Mercaptanggruppenäquivalent pro Allylgruppenäquivalent), lässt sich wie in Beispiel 1 beschrieben photopolymerisieren.

Beispiel 8

Man erhitzt ein Gemisch aus 2,2 - Bis - (3,5 - diallyl - 4 - hydroxyphenyl) - propan (194 g), Glycidylmethacrylat (154 g), Tetramethylammoniumchlorid (0,7 g) und 2,6 - Di - tert. - butyl - p - kresol (2,8 g) im Verlauf 1 Stunde auf 95°C und rührt noch 3,5 Stunden bei dieser Temperatur weiter, was 2,2- Bis - (3,5 - diallyl - 4 - (3 - methacryloyloxy) - 2 - hydroxypropoxy) - phenyl) - propan, d.h. die Verbindung der Formel

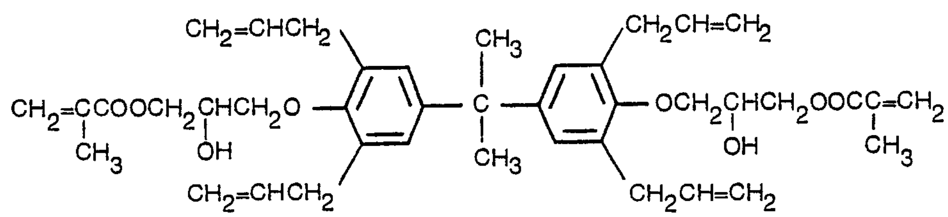

L

liefert.

Diese Verbindung (50 g) wird gemäss Beispiel 1 mit Bernsteinsäureanhydrid (11,9 g) verestert. Der entstandene, vorwiegend aus 2,3 - Bis - (3,5 - diallyl - 4 - (3 - (methacryloyloxy) - 2 - (2 - carboxyäthylcarbonyloxy) - propoxy) - phenyl) - propan) bestehende Ester im Gemisch mit Pentaerythrittetrathioglykolat (1 Mercaptangruppenäquivalent pro Allylgruppenäquivalent) lässt sich wie in Beispiel 1 beschrieben photopolymerisieren.

Beispiel 9

Man erhitzt ein Gemisch (85 g) aus 1,3 - Diallyl - 2,4 - dihydroxybenzol und 1,5 - Diallyl - 2,4-dihydroxybenzol, erhalten durch Claisen-Umlagerung von Resorcin-diallyläther, 1 Stunde lang mit 127 g Glycidylmethacrylat, 0,8 g 2,6 - Di - tert. - butyl - p - kresol und 0,4 g Tetramethylammoniumchlorid auf 100°C und rührt das Ganze noch 5 Stunden bei dieser Temperatur weiter, was ein Gemisch aus 1,3- und 1,5 - Diallyl - 2,4 - bis - (3 - (methacryloyloxy) - 2 - hydroxypropoxy) - benzol, d.h. den Verbindungen der Formelin

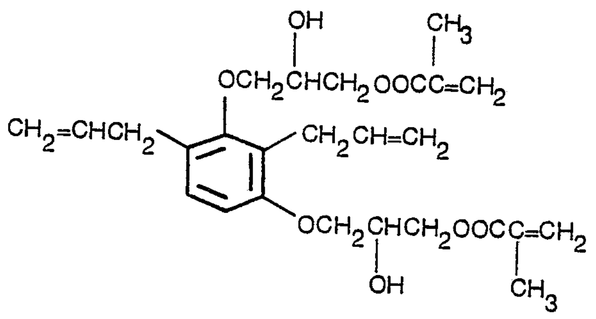

LI

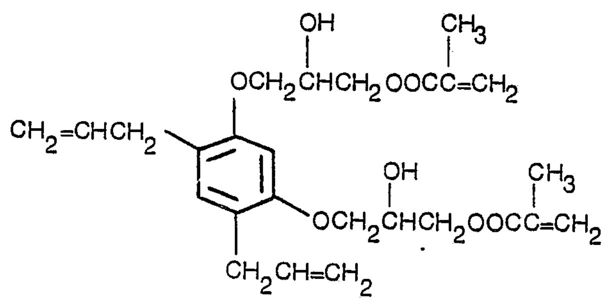

LII

ergibt.

Dieses Gemisch (50 g) wird gemäss Beispiel 1 mit Bernsteinsäureanhydrid (16,8 g) verestert. Ein Gemisch aus dem so erhaltenen, vorwiegend aus 1,3 - Diallyl - 2,4 - bis - (3 - (methacryloyloxy) - 2 - (2 - caboxyäthylcarbonyloxy) - propoxy) - benzol und dessen 1,5-Diallylisomer bestehenden Estergemischs mit Pentaerythrit-tetrathioglykolat (1 Mercaptangruppenäquivalent pro Allylgruppenäquivalent) lässt sich wie in Beispiel 1 beschrieben photopolymerisieren.

Beispiel 10

1,3 - Diglycidyl - 5,5 - dimethylhydantoin (100 g) wird durch 6 Stunden langes Erhitzen auf 120°C mit 94,75 g 2,2 - Bis - (3 - allyl - 4 - hydroxyphenyl) - propan in 195 g 0,6 g Tetramethylammoniumchlorid enthaltendem Cyclohexanon vorverlängert. Nach Ablauf der 6 Stunden ist der Epoxidgehalt des Gemischs auf 1,0 val/kg gefallen. Das Zwischenprodukt entspricht im wesentlichen der Formell LIII, worin $R^{31}$ und $R^{32}$ je eine Glycidylgruppe und x eine positive ganze Zahl bedeuten. Nach Abkühlen des Gemischs auf 80°C versetzt man mit 0,4 g 2,6 - Di - tert. - butyl - p - kresol und danach tropfenweise im Verlauf von 20 Minuten mit 17,2 g Methacrylsäure. Dann erhitzt man 6 Stunden auf 100°C und bricht die Reaktion auf dieser Stufe ab, wenn der Epoxidgehalt des Harzes auf 0,29 val/kg gefallen ist. Das Produkt ist im wesentlichen ein Gemisch der Formel

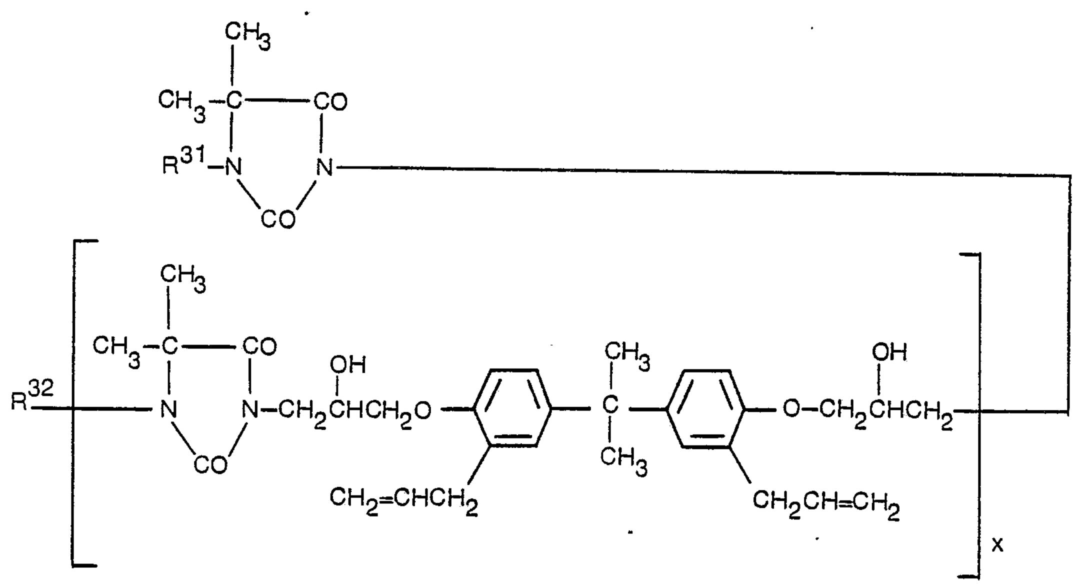

LIII

worin ein Teil der Gruppen $R^{31}$ und $R^{32}$ 3 - (Methacryloyloxy) - 2 - hydroxypropylgruppen und der Rest davon Glycidylgruppen bezeichnet.

Das Gemisch (50 g) wird gemäss Beispiel 1 mit Bernsteinsäureanhydrid (10 g) verestert. Ein Gemisch des so erhaltenen veresterten Gemischs mit Pentaerythrit-tetrathioglykolat (1 Mercaptangruppenäquivalent pro Allylgruppenäquivalent) lässt sich wie in Beispiel 1 beschrieben photopolymerisieren.

Beispiel 11

Man erhitzt Benzophenon-3,4,3',4'-tetracarbonsäuredianhydrid (400 g, aus Essigsäureanhydrid umkristallisiert) und 1 200 g Allylalkohol 1 Stunde zum Rückfluss und entfernt dann den Überschüssigen Allylalkohol durch Vakuumdestillation, wobei 540 g Benzophenon - 3,4,3',4' - tetracarbonsäure - X,X'-diallylester verbleiben.

Diese Diallylester (450 g) löst man in 1 200 g Epichlorhydrin, erhitzt auf 95°C, versetzt mit einer Lösung von 2,05 g Tetramethylammoniumchlorid in 2,05 ml Wasser und erhitzt das Ganze 3 Stunden lang unter Rühren auf 95°C. Dann kühlt man auf 55°—60°C und versetzt mit einer weiteren Menge Tetramethylammoniumchlorid (1,7 g) gelöst in 1,71 ml Wasser. Unter partiellem Vakuum bringt man das Gemisch in einer zur fortlaufenden Entfernung von Wasser aus dem Gemisch eingerichteten Apparatur bei 55°—57°C zum Rückfluss. Unter Rühren versetzt man im Verlauf von 2½ Stunden tropfenweise mit 50%iger wässriger Natronlauge (180 g) und rührt dann noch 1½ Stunden weiter. Das Gemisch wird abgekühlt, das Vakuum aufgehoben, dann Wasser (340 ml) dazugegeben, das Gemisch geschieden und die organische Schicht zunächst mit 5%iger wässriger Lösung (223 ml) von Natriumdihydrogenorthophosphat und dann mit 223 ml Wasser gewaschen. Ueberschüssiges Epichlorhydrin wird bei vermindertem Druck abdestilliert, wobei 450 g Benzophenon - 3,4,3',4' - tetracarbonsäure - X,X' - diallyl - Y,Y' - diglycidylester als viskoses Oel mit einem Epoxidgehalt von 3,1 val/kg zurückbleiben.

Die Diallyl-diglycidylester (200 g) erhitzt man in Gegenwart von 0,6 g Tetramethylammoniumchlorid und 0,4 g 2,6 - Di - tert. - butyl - p - kresol auf 120°C und gibt im Verlauf von 35 Minuten tropfenweise Methacrylsäure (52,6 g) dazu. Man rührt noch 35 Minuten weiter und lässt dann das Gemisch abkühlen.

Das erwünschte Produkt Benzophenon - 3,4,3',4' - tetracarbonsäure - X,X' - diallyl - Y,Y' - bis - (3-(methacryloyloxy) - 2 - hydroxypropyl) - ester (d.h. entsprechend der Formel XXI, worin eines von $R^9$ und $R^{10}$ bzw. $R^{11}$ und $R^{12}$ jeweils für eine Allylgruppe und die zwei verbleibenden Symbole unter $R^9$ und $R^{12}$ jeweils für eine Gruppe der Formel XXII stehen, wobei $R^5$ eine Methylgruppe und $R^2$ eine Gruppe der Formel I mit R als Wasserstoffatom darstellen) ist ein hellgelbes viskoses Oel.

Dieses Produkt (50 g) wird gemäss Beispiel 1 mit Bernsteinsäureanhydrid (11 g) verestert. Ein Gemisch des so erhaltenen, vorwiegend aus Benzophenon - 3,4,3',4' - tetracarbonsäure - X,X' - diallyl - Y,Y'- bis - (3 - (methacryloyloxy) - 2 - (2 - carboxyäthylcarbonyloxy) - propylestern bestehenden Esters mit Pentaerythrit - tetrathioglykolat (1 Mercaptangruppenäquivalent pro Allygruppenäquivalent) lässt sich wie in Beispiel 1 beschrieben, jedoch unter Weglassung des Benzildimethylketals, photopolymerisieren.

Beispiel 12

Man vermischt 1,3 - Diglycidyl - 5,5 - dimethylhydantoin (50 g) mit 2,6 - Di - tert. - butyl - p - kresol (0,14 g) und erhitzt auf 100°C. Im Verlauf 1 Stunde versetzt man das Gemisch mit eine 5%fige Chromoctanoatlösung in Petroläther (0,05 g) enthaltender Methacrylsäure (35,5 g) und 2,6 - Di - tert. - butyl - p-kresol (0,2 g).

Dieses Gemisch erhitzt man 5 Stunden auf 100°C und versetzt dann mit 2,6 - Di - tert. - butyl - p - kresol (0,05 g) enthaltender Methacrylsäure (4,5 g). Das Erhitzen wird noch 2½ Stunden fortgesetzt und dann eine weitere Menge Methacrylsäure (2,2 g) und 2,6 - Di - tert. - butyl - p - kresol (0,02 g) dazugegeben. Man erhitzt 2 Stunden auf 100°C, versetzt mit Methacrylsäure (1,5 g) und 2,6 - Di - tert. - butyl - p - kresol (0,2 g) und erhitzt noch 3/4 Stunde auf 100°C. Der gefundene Epoxidgehalt dieses Produkts beträgt 0,14 val/kg.

Im Verlauf 1 Stunde gibt man 4 - (N,N - Diallylamino) - phthalsäureanhydrid (86,3 g, gemäss Beispiel 2 der britischen Patentschrift Nr. 1 563 577 hergestellt) zu dem obigen Gemisch, rührt noch 1 Stunde bei 100°C und kühlt dann auf Raumtemperatur ab.

Dieses Produkt, nämlich 1,3 - Bis - (3 - (methacryloyloxy) - 2 - (2 - carboxy - 4- und -5 - diallylaminophenylcarbonyloxy) - propyl) - 5,5 - dimethylhydantoin (8 g) vermischt man mit Trimethylolpropan-trithioglykolat (4 g, d.h. 0,9 Mercaptangruppenäquivalent pro Allyläquivalent) und 2,2' - Azobis-(2 - methylpropionitril) (0,4 g). Das Gemisch wird als 10 µm dicke Beschichtung auf ein Stück Weissblech aufgebracht und 20 Minuten auf 120°C erhitzt. Die Beschichtung härtet zu einer harten klebfreien Oberfläche aus.

**Patentansprüche**

1. Polymerisierbare Zusammensetzungen, dadurch gekennzeichnet, dass sie aus

(a) einer Verbindung, die im Molekül (i) mindestens eine unter Acryloyloxy- und Methacryloyloxygruppen ausgewählte Gruppe, (ii) mindestens eine unter jeweils entweder direkt oder über ein Sauerstoffatom oder eine Oxycarbonylgruppe (—OCO—) an ein zu einem aromatischen oder cycloaliphatischen Kern gehöriges Kohlenstoffatom gebundenen Allyl-, Methallyl- und 1-Propenylgruppen ausgewählte Gruppe und (iii) mindestens eine Carbonsäuregruppe (—COOH) enthält, und

(b) einem solchen Anteil einer Verbindung, die pro Molekül mindestens zwei direkt an ein bzw. mehrere aliphatische Kohlenstoffatome gebundene Mercaptangruppen enthählt, dass mindestens 0,8 solche Mercaptangruppen auf eine unter Allyl-, Methallyl- und 1-Propenylgruppen ausgewählte Gruppe in (a), jedoch weniger als 1,0 solche Mercaptangruppen auf eine unter Acryloyl-, Methacryloyl-, Allyl-, Methallyl- und 1-Propenylgruppen ausgewählte Gruppe in (a) kommen, bestehen, wobei die Summe der Gruppen (i) und (ii) zwei oder mindestens drei bedeutet.

2. Zusammensetzungen nach Anspruch 1, dadurch gekennzeichnet, dass die Summe der Gruppen (i) und (ii) in (a) mindestens drei beträgt.

3. Zusammensetzungen nach Anspruch 1 oder 2, dadurch gekennzeichnet, dass diese Acryloyloxy- oder Methacryloyloxygruppe bzw. -gruppen jeweils über eine Gruppe der Formel

$$-CH_2\underset{\displaystyle OR}{\underset{|}{C}}HCH_2- \qquad \text{I}$$

worin R entweder für ein Wasserstoffatom oder für den einwertigen Acylrest einer mindestens zweibasischen Carbonsäure steht, an einen eromatischen, cycloaliphatischen oder heterocyclischen Kern gebunden ist bzw. sind.

4. Zusammensetzungen nach Anspruch 3, dadurch gekennzeichnet, dass R ferner der Formel

$$-CO-R^1-COOH \qquad \text{II}$$

entspricht, worin $R^1$ eine gegebenenfalls durch eine oder mehrere Allyl-, Methallyl- oder 1-Propenylgruppen oder eine oder mehrere Carbonsäuregruppen substituierte Alkylen-, Arylen- oder Aralkylengruppe darstellt, wobei diese Alkylengruppe bzw. der Alkylenteil der Aralkylengruppe 2 bis 10 sowie diese Arylengruppe bzw. der Arylenteil der Aralkylengruppe 6 bis 10 Kohlenstoffatome aufweisen.

5. Zusammensetzungen nach einem der vorhergehenden Ansprüche, dadurch gekennzeichnet, dass als Komponente (a) ein mehrwertiges Phenol vorliegt, in dem mindestens zwei phenolische Hydroxylgruppen über eine wie in Anspruch 3 oder 4 definerte carbonsäurehaltige Gruppe der Formel I mit Acryloyl- oder Methacryloylgruppen verestert sowie mindestens zwei phenolische Hydroxylgruppen direkt mit unter Allyl-, Methallyl- und 1-Propenylgruppen ausgewählten Gruppen veräthert sind.

6. Zusammensetzungen nach einem der Ansprüche 1 bis 4, dadurch gekennzeichnet, dass als Komponente (a) ein mehrwertiges Phenol vorliegt, in dem mindestens zwei phenolische Hydroxylgruppen über eine wie in Anspruch 3 oder 4 definierte carbonsäurehaltige Gruppe der Formel I mit unter Acryloyl- und Methacryloylgruppen ausgewählten Gruppen verestert sind, wobei das mehrwertige Phenol an Kohlenstoffatomen in einem oder mehreren Benzol- oder Naphthalinkern(en) direkt durch mindestens zwei unter Allyl-, Methallyl- und 1-Propenylgruppen ausgewählten Gruppen substituiert ist.

7. Zusammensetzungen nach einem der vorhergehenden Ansprüche, dadurch gekennzeichnet, dass als Komponente (b) ein Ester einer Monomercaptanalkylencarbonsäure mit einem mehrwertigen Alkohol oder eines aliphatischen einwertigen Monomercaptanalkohols mit einer Polycarbonsäure vorliegt.

8. Druckplatten oder gedruckte Schaltungen, hergestellt aus einer Zusammensetzung nach einem der vorhergehenden Ansprüche, worin die Summe der ungesättigten Gruppen (i) und (ii) in (a) plus denen der Mercaptangruppen in (b) mehr als vier beträgt, indem man die Zusammensetzung als Ueberzug auf ein Substrat aufbringt, mit aktinischer Strahlung so belichtet, dass Teile des Ueberzugs photopolymerisiert werden, und den Ueberzug mit einer verdünnten wässrigalkalischen Lösung wäscht, um die unpolymerisierten Anteile zu entfernen, während die photopolymerisierten Teile an Ort und Stelle verbleiben.

9. Druckplatten und gedruckte Schaltungen, hergestellt aus einer Zusammensetzung nach einem der vorhergehenden Ansprüche, worin die Summe der ungesättigten Gruppen (i) und (ii) in (a) plus denen der Mercaptangruppen in (b) nur vier beträgt, indem man die Zusammensetzung als Ueberzug auf ein Substrat aufbringt, mit aktinischer Strahlung so belichtet, dass Teile des Ueberzugs photopolymerisiert werden, und den Ueberzug mit einer verdünnten wässrigalkalischen Lösung wäscht, um die unpolymerisierten Anteile zu entfernen, während die photopolymerisierten Teile an Ort und Stelle verbleiben.

10. Verbindungen, dadurch gekennzeichnet, dass sie im Molekül (i) mindestens eine unter Acryloyloxy- und Methacryloyloxygruppen ausgewählte Gruppe, (ii) mindestens eine unter jeweils entweder direkt oder über ein Sauerstoffatom oder eine Oxycarbonylgruppe (—OCO—) an ein zu einem aromatischen oder cycloaliphatischen Kern gehöriges Kohlenstoffatom gebundenen Allyl-, Methallyl- und 1-Propenylgruppen ausgewählte Gruppe und (iii) mindestens eine Carbonsäuregruppe (—COOH) enthalten und ferner einer der Formeln

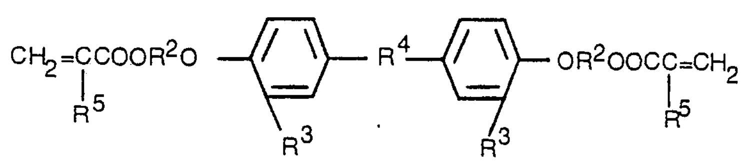

III

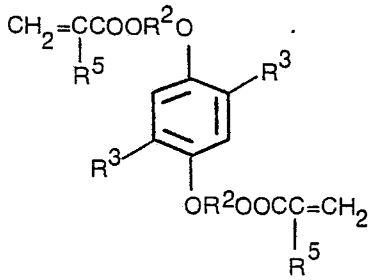

IV

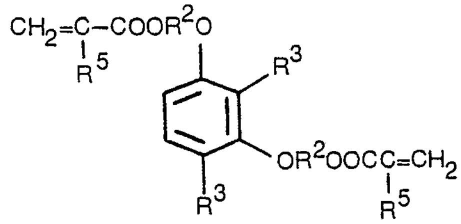

V

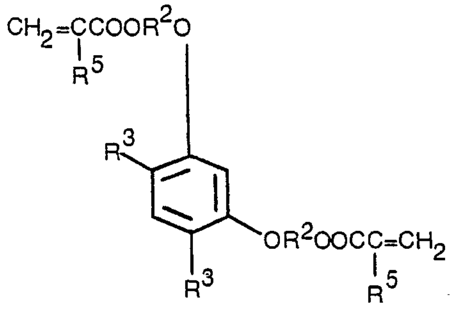

VI

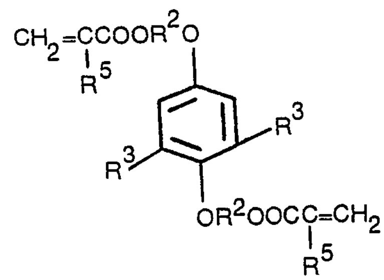

VII

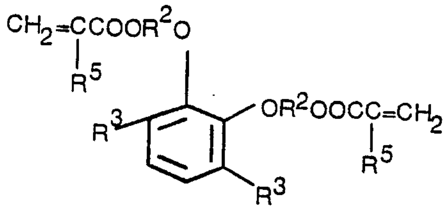

VIII

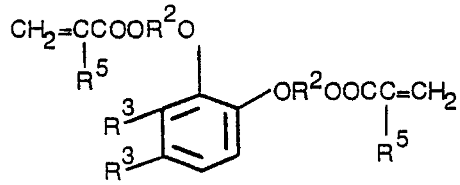

IX

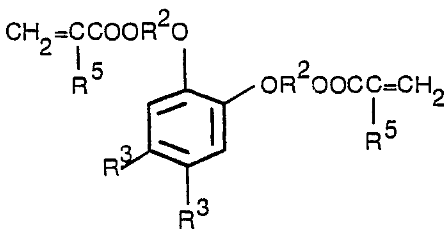

X

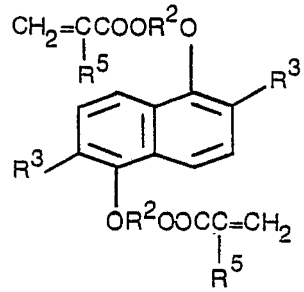

XI

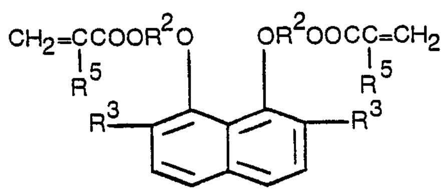

XII

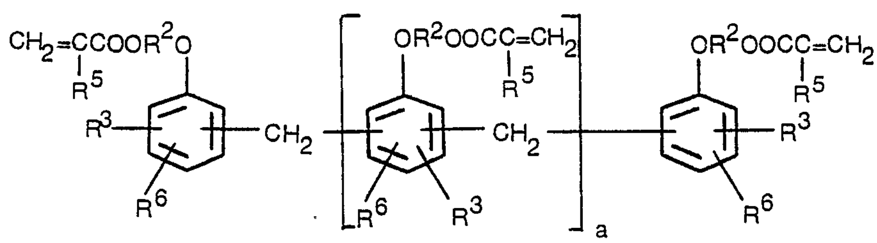

XIII

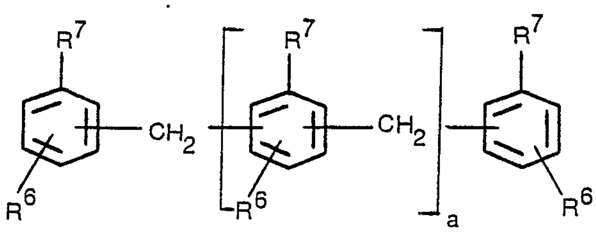

XIV

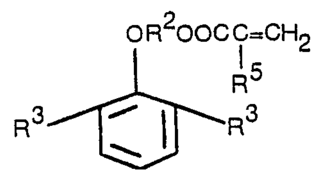

XV

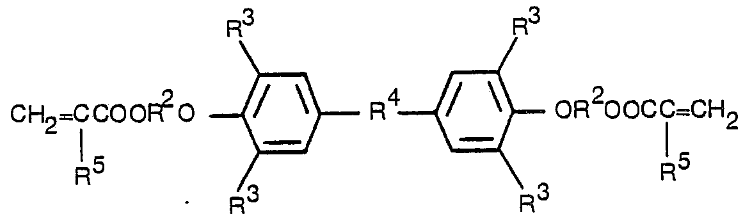

XVI

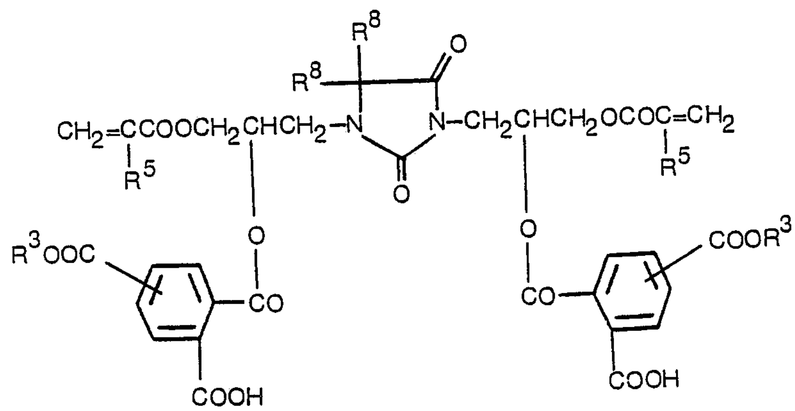

XVII

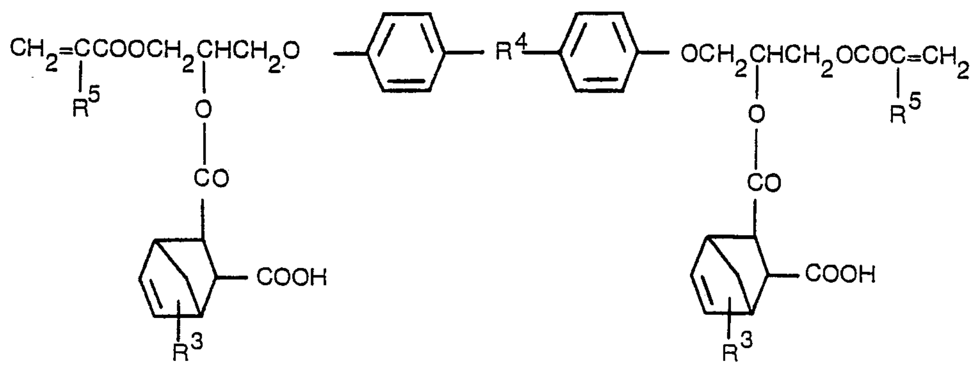

XVIII

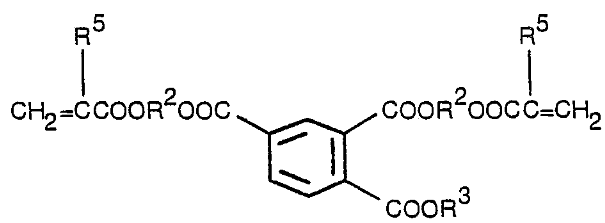

XIX

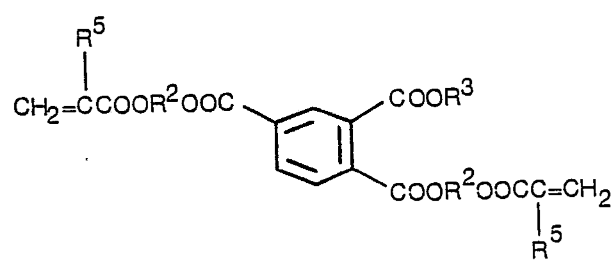

XX

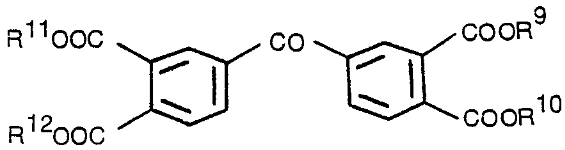

XXI

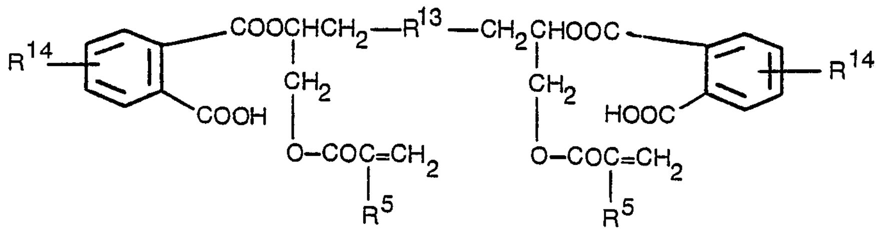

XXIII

entsprechen, worin a eine ganze Zahl von 1 bis 6 ist, $R^2$ jeweils eine carbonsäurehaltige Gruppe der Formel

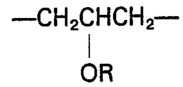

I

worin R für den einwertigen Acylrest einer mindestens zweibasischen Carbonsäure steht, $R^3$ jeweils eine Allyl-, Methallyl- oder 1-Propenylgruppe, mit der Massgabe, dass sich in Formeln XIII und XIV die $—CH_2—$ und $R^3$-Gruppen jeweils in ortho- oder para-Stellung zur angegebenen Gruppe $CH_2=C(R^5)COOR^2O—$ und $R^7$- befinden, $R^4$ eine Kohlenstoff- Kohlenstoffbindung, eine Alkylen- oder Alkylidengruppe mit bis zu 5 Kohlenstoffatomen, ein Aethersauerstoffatom, ein Schwefelatom oder eine Gruppe der Formel —CO—, —SS— oder $—SO_2—$, $R^5$ jeweils ein Wasserstoffatom oder eine Methylgruppe, $R^6$ jeweils ein Wasserstoff-, Chlor- oder Bromatom oder eine Alkylgruppe mit 1 bis 4 Kohlenstoffatomen, $R^7$ jeweils eine Gruppe der Formel $CH_2=C(R^5)COOR^2O—$ oder eine Allyloxy-, Methallyoxy- oder 1-Propenyloxygruppe, derart dass mindestens ein $R^7$ eine solche Gruppe der Formel $CH_2=C(R^5)COOR^2O—$ und mindestens zwei $R^7$ je eine Allyloxy-, Methallyloxy- oder 1-Propenyloxygruppe darstellen, und $R^8$ eine Alkylgruppe mit 1 bis 10 Kohlenstoffatomen, eine Aralkylgruppe mit 7 bis 16 Kohlenstoffatomen oder eine Arylgruppe mit 6 bis 10 Kohlenstoffatomen bedeuten, eines von $R^9$ und $^{10}$ bzw. $R^{11}$ und $R^{12}$ die gleiche Bedeutung haben und je für eine Allyl- oder Methallylgruppe stehen und die verbleibenden Symbole $R^9$ und $R^{10}$ bzw. $R^{11}$ und $R^{12}$ jeweils für den Rest eines Alkohols nach Wegnahme des Wasserstoffatoms einer alkoholischen Hydroxylgruppe stehen, wobei dieser Rest sowohl eine Carbonsäuregruppe als auch eine Acryloyloxy- oder Methacryloyloxygruppe enthält, sowie $R^{13}$ eine Gruppe der Formel

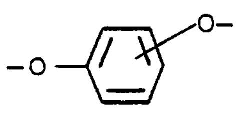

XXIV

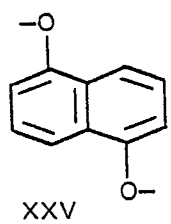

XXV

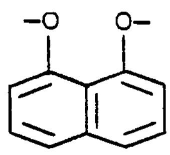

XXVI

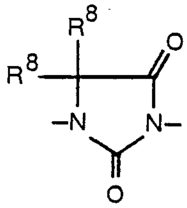

XXVII

oder

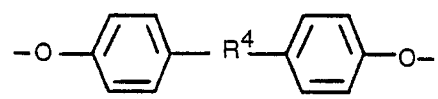

XXVIII

und $R^{14}$ eine Allyl-, Methallyl-, 1-Propenyl-, Allyloxycarbonyl-, Methallyloxycarbonyl-, 1-Propenyloxycarbonyl-, Diallylamino-, Dimethylallylamino- oder Di-(1-propenyl)-aminogruppe darstellen.

**Revendications**

1. Compositions polymérisables caractérisées en ce qu'elles sont constituées:

(a) d'un composé dont la molécule contient: (i) au moins un radical pris dans l'ensemble constitué par les radicaux acryloyloxy et méthacryloyloxy, (ii) au moins un radical pris dans l'ensemble constitué par les radicaux allyle, méthallyle et propène-1 yle, relié soit directement soit par l'intermédiaire d'un atome d'oxygène ou d'un radical oxycarbonyle (—OCO—) à un atome de carbone appartenant à un noyau aromatique ou cycloaliphatique, et (iii) au moins un radical carboxy (—COOH), et

(b) d'un composé qui contient, par molécule, au moins deux radicaux mercapto liés directement à un ou plusieurs atomes de carbone aliphatiques, en une quantité telle qu'il y ait au moins 0,8 de ces radicaux mercapto pour un radical dans (a) appartenant à l'ensemble constitué par les radicaux allyle, méthallyle et propène-1 yle mais moins de 1,0 de ces radicaux mercapto pour un radical dans (a) appartenant à l'ensemble constitué par les radicaux acryloyle, méthacryloyle, allyle, méthallyle et propène-1 yle, la somme des nombres des radicaux (i) et (ii) étant égale à 2 ou au moins à 3.

2. Compositions selon la revendication 1 caractérisées en ce que la somme des nombres des radicaux (i) et (ii) dans (a) est au moins égale à 3.

3. Compositions selon l'une des revendications 1 et 2, caractérisées en ce que le ou les radicaux acryloyloxy ou méthacryloyloxy sont liés chacun, par un radical répondant à la formule I:

$$-CH_2\underset{\displaystyle OR}{\underset{|}{C}}HCH_2- \qquad I$$

dans laquelle R représente soit un atome d'hydrogène soit un radical acyle univalent dérivant d'un acide carboxylique à au moins deux radicaux acides, à un noyau aromatique, cycloaliphatique ou hétérocyclique.

4. Compositions selon la revendication 3 caractérisées en ce que R répond à la formule II:

$$-CO-R^1-COOH \qquad (II)$$

dans laquelle $R^1$ représente un radical alkylène, arylène ou aralkylène éventuellement porteur d'un ou de plusieurs radicaux allyles, méthallyles ou propène-1 yles ou d'un ou plusieurs radicaux carboxy, ce radical alkylène ou la partie alkylène du radical aralkylène contenant de 2 à 10 atomes de carbone, et ce radical arylène ou la partie arylène du radical aralkylène contenant de 6 à 10 atomes de carbone.

5. Compositions selon l'une quelconque des revendications précédentes, caractérisées en ce qu'elles contiennent, comme composante (a), un polyphénol dans lequel au moins deux radicaux hydroxy phenoliques sont estérifiés par l'intermédiaire d'un radical carboxylé de formule I tel que défini à la revendication 3 ou 4 avec des radicaux acryloyles ou méthacryloyles, et au moins deux radicaux hydroxy phénoliques sont éthérifiés directement par des radicaux pris dans l'ensemble constitué par les radicaux allyle, méthallyle et propène-1 yle.

6. Compositions selon l'une quelconque des revendications 1 à 4, caractérisées en ce qu'elles contiennent, comme composante (a), un polyphénol dans lequel au moins deux radicaux hydroxy phénoliques sont estérifiés par l'intermédiaire d'un radical carboxylé de formule I tel que défini à la revendication 3 ou 4, avec des radicaux pris dans l'ensemble constitué par les radicaux acryloyle et méthacryloyle, le polyphénol portant, comme substituants directement fixés sur des atomes de carbone d'un ou plusieurs noyaux benzéniques ou naphtaléniques, au moins deux radicaux pris dans l'ensemble constitué par les radicaux allyle, méthallyle et propène-1 yle.

7. Compositions selon l'une quelconque des revendications précédentes, caractérisées en ce qu'elles contiennent, comme composante (b), un ester formé par un acide monomercapto - alkylène - carboxylique avec un polyol, ou par un monomercapto - alcool aliphatique monofonctionnel avec un acide polycarboxylique.

8. Clichés d'imprimerie ou circuits imprimés que l'on a fabriqués à partir d'une composition selon l'une quelconque des revendications précédentes dans laquelle le nombre total des radicaux insaturés (i) et (ii) dans (a) augmenté de celui des radicaux mercapto dans (b) est supérieur à 4, en appliquant une couche de la composition sur un substràt, en exposant cette couche à un rayonnement actinique de telle façon que des parties du revêtement avec une solution aqueuse alcaline diluée pour éliminer les parties qui n'ont pas été polymérisées, les parties polymérisées restant alors en place.

9. Clichés d'imprimerie et circuits imprimés que l'on a fabriqués à partir d'une composition selon l'une quelconque des revendications précédentes dans laquelle le nombre total des radicaux insaturés (i) et (ii) dans (a) augmenté de celui des radicaux mercapto dans (b) n'est que de quatre, en appliquant une couche de la composition sur un substrat, en exposant cette couche à un rayonnement actinique de telle façon que des parties du revêtement soient photopolymérisées, et en lavant le revêtement avec une solution aqueuse alcaline diluée pour éliminer les parties non polymérisées, les parties photopolymérisées restant alors en place.

10. Composés caractérisés en ce qu'ils contiennent, dans leur molécule, (i) au moins un radical pris dans l'ensemble constitué par les radicaux acryloyloxy et méthacryloyloxy, (ii) au moins un radical pris dans l'ensemble constitué par les radicaux allyle, méthallyle et propène-1 yle, relié soit directement soit par

l'intermédiaire d'un atome d'oxygène ou d'un radical oxycarbonyle (—OCO—) à un atome de carbone appartenant à un noyau aromatique ou cycloaliphatique, et (iii) au moins un radical carboxy (—COOH), et en ce qu'ils répondent à l'une des formules suivantes:

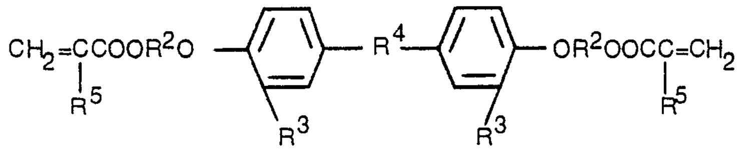

III

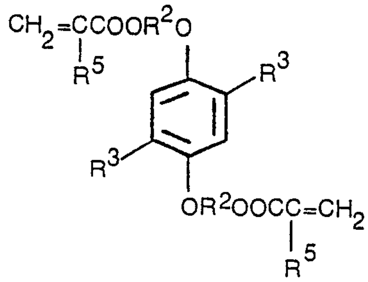

IV

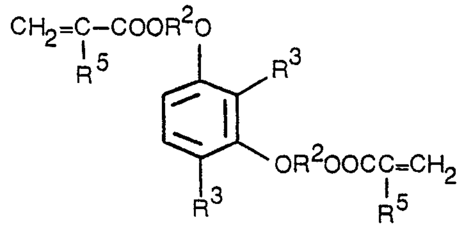

V

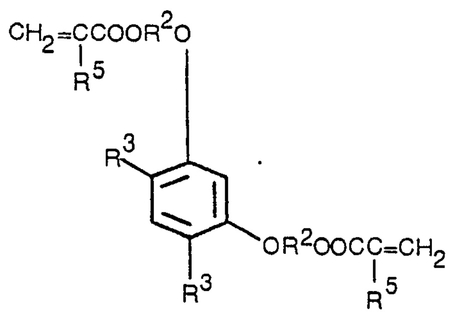

VI

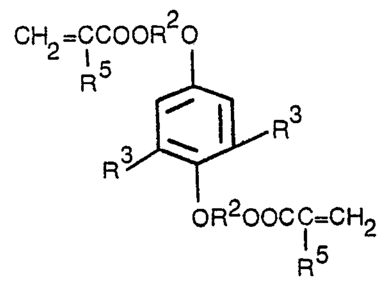

VII

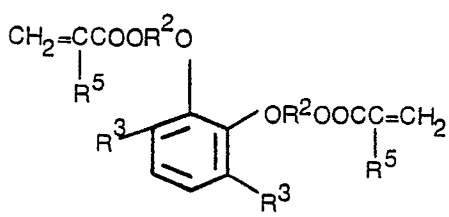

VIII

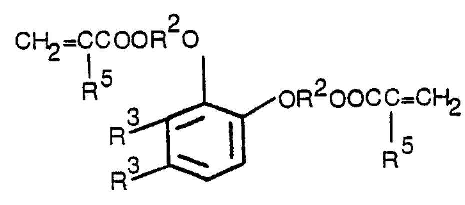

IX

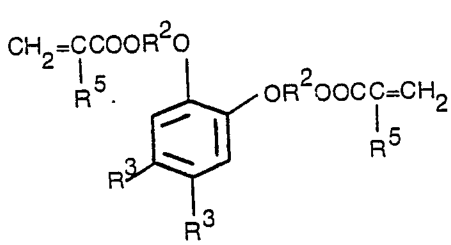

X

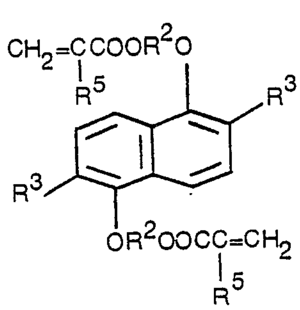

XI

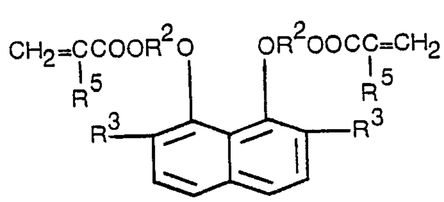

XII

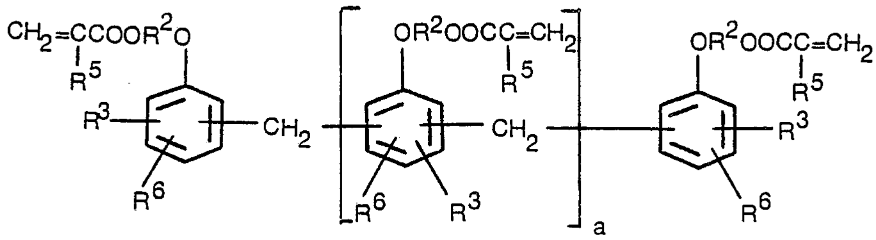

XIII

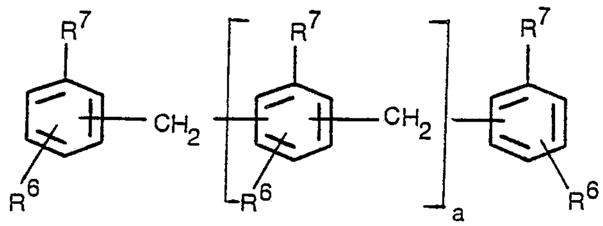

XIV

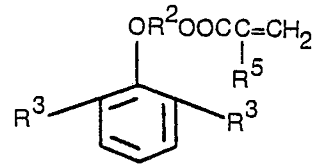

XV

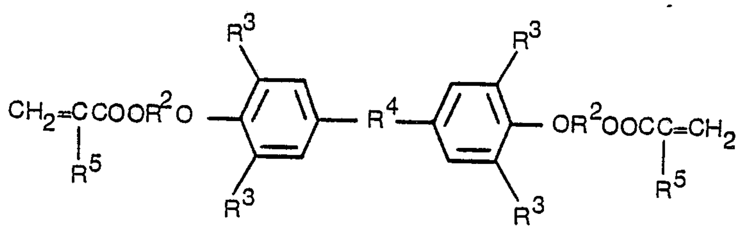

XVI

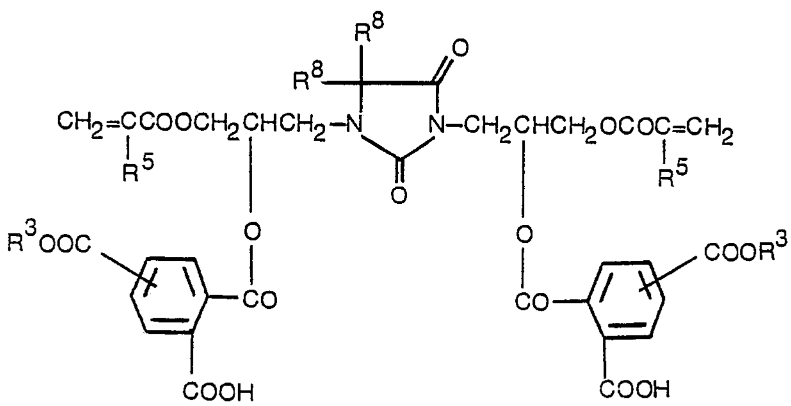

XVII

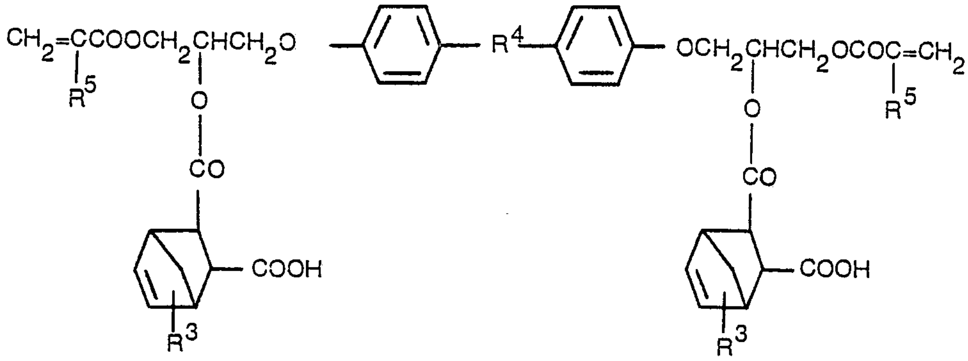

XVIII

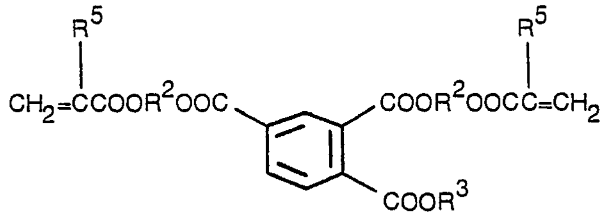

XIX

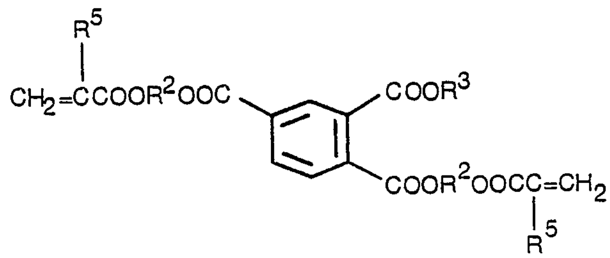

XX

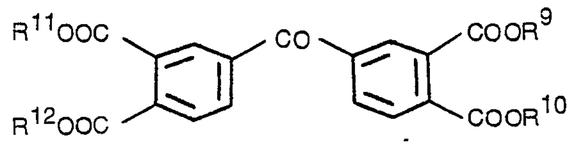

XXI

et

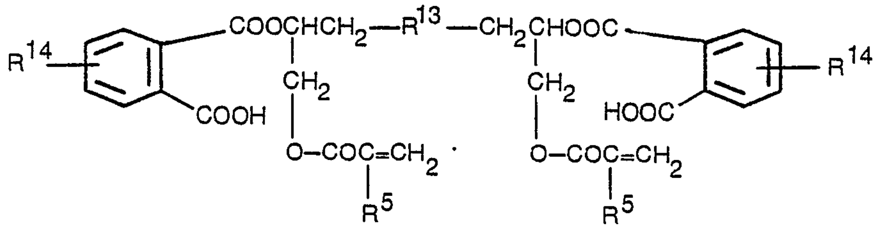

XXIII

dans lesquelles:

a représente un nombre entier de 1 à 6,

les $R^2$ représentent chacun un radical porteur d'un radical carboxy qui répond à la formule I:

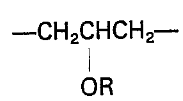

I

dans laquelle R représente un radical acyle univalent provenant d'un acide carboxylique à au moins deux radicaux acides,

les $R^3$ représentent chacun un radical allyle, méthallyle ou propène-1 yle, avec la condition que, dans les formules XIII et XIV, les radicaux $-CH_2-$ et $R^3$ se trouvent chacun en position ortho ou en position para relativement au radical $CH_2=C(R^5)COOR^2O-$ représenté ou au radical $R^7$,

$R^4$ représente une liaison carbone-carbone, un radical alkylène ou alkylidène contenant au plus 5 atomes de carbone, un atome d'oxygène de fonction éther, un atome de soufre ou un radical —CO-, —SS- ou $-SO_2-$,

les $R^5$ représentent chacun un atome d'hydrogène ou un radical méthyle,

les $R^6$ représentent chacun un atome d'hydrogène, de chlore ou de brome ou un alkyle contenant de l à 4 atomes de carbone,

les $R^7$ représentent chacun un radical $CH_2=C(R^5)COOR^2O-$ ou un radical allyloxy, méthallyloxy ou propène-1 yloxy, de telle façon qu'au moins un des $R^7$ représente un tel radical $CH_2=C(R^5)COOR^2O-$ et qu'au moins des $R^7$ représentent chacun un radical allyloxy, méthallyloxy ou propène-1 yloxy,

$R^8$ répresente un alkyle contenant de 1 à 10 atomes de carbone, un aralkyle contenant de 7 à 16 atomes de carbone ou un aryle contenant de 6 à 10 atomes de carbone,

l'un des symboles $R^9$ et $R^{10}$ et l'un des symboles $R^{11}$ et $R^{12}$ ont la même signification et représentent chacun un radical allyle ou méthallyle, les symboles restants représentant chacun le radical d'un alcool dont on a enlevé le groupe hydroxy alcoolique, ce radical contenant à la fois un radical carboxy et un radical acryloyloxy ou méthacryloyloxy,

$R^{13}$ représente un radical répondant à l'une des formules:

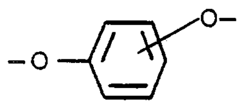

XXIV

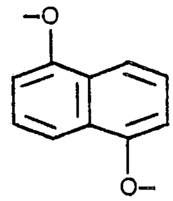

XXV

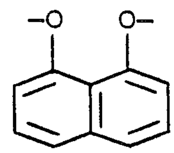

XXVI

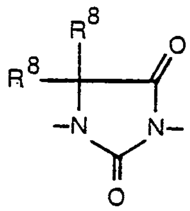

XXVII

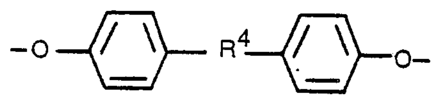

XXVIII

et

$R^{14}$ représente un radical allyle, méthallyle, propène-1 yle, allyloxycarbonyle, méthallyloxycarbonyle, propène-1 yloxycarbonyle, diallylamino, diméthylallylamino ou di-(propène-1 yl)-amino.

**Claims**

1. Polymerisable compositions comprising (a) a compound containing in the molecule (i) at least one group selected from acryloyloxy and methacryloyloxy groups, (ii) at least one group selected from allyl, methallyl, and 1-propenyl groups each of which is attached, either directly or through an oxygen atom or an oxycarbonyl group (—OCO—), to a carbon atom which forms part of an aromatic or cycloaliphatic nucleus, and (iii) at least one carboxylic acid (—COOH) group,

(b) a compound containing, per molecule, at least two mercaptan groups directly attached to one or more aliphatic carbon atoms, in a proportion as to supply at least 0.8 such mercaptan group per group selected from allyl, methallyl and 1-propenyl groups in (a) but less than 1.0 such mercaptan group per group selected from acryloyl, methacryloyl, allyl, methallyl, and 1-propenyl groups in (a), the total of groups (i) and (ii) meaning (sic) two or at least three.

2. Compositions according to claim 1, in which the total of the groups (i) and (ii) in (a) is at least three.

3. Compositions according to claim 1 or 2, in which this/these acryloyloxy or methacryloyloxy group or groups is/are attached to an aromatic, cycloaliphatic, or heterocyclic nucleus through a group of the formula

$$\begin{array}{c}—CH_2CHCH_2—\\ |\\ OR\end{array} \qquad I$$

where R denotes either a hydrogen atom or a monovalent acyl residue of an at least dibasic carboxylic acid.

4. Compositions according to claim 3, wherein R in is further of the formula

$$—CO—R^1COOH \qquad II$$

where $R^1$ denotes an alkylene, arylene, or aralkylene group, any of which groups may be substituted by one or more allyl, methallyl, or 1-propenyl groups or by one or more carboxylic acid groups, the said alkylene group and the alkylene portion of the aralkylene group having from 2 to 10 carbon atoms, and the said arylene group and the arylene portion of the aralkylene group having from 6 to 10 carbon atoms.

5. Compositions according to any one of the preceding claims, in which component (a) is a polyhydric phenol, at least two phenolic hydroxyl groups of which are esterified with acryloyl or methacryloyl groups through a carboxylic acid-containing group of the formula I as defined in claim 3 or 4, and at least two phenolic hydroxyl groups of which are directly etherified with groups chosen from allyl, methallyl, and 1-propenyl groups.

6. Compositions according to any one of claims 1 to 4, in which component (a) is a polyhydric phenol, at least two phenolic hydroxyl groups of which are esterified with groups chosen from acryloyl and methacryloyl groups through a carboxylic acid-containing group of the formula I as defined in claim 3 or 4, the polyhydric phenol being substituted directly on carbon atoms in one or more benzene or naphthalene nucleus or nuclei by at least two groups selected from allyl, methallyl, and 1-propenyl groups.

7. Compositions according to any one of the preceding claims, wherein component (b) is an ester of a monomercaptan - alkylenecarboxylic acid with a polyhydric alcohol or of an aliphatic monomercaptan - monohydric alcohol with a polycarboxy - lic acid.

8. Printing plates or printed circuits produced from a composition as claimed in any one of the preceding claims wherein the total of the unsaturated groups (i) and (ii) in (a) plus those of the mercaptan groups in (b) is more than four, in that the composition is applied as a coating to a substrate, exposed to actinic radiation such that parts of the coating are photopolymerised, and the coating is washed with a dilute aqueous alkaline solution to remove the unpolymerised portions while leaving the photopolymerised portions in place.

9. Printing plates and printed circuits produced from a composition as claimed in any one of the preceding claims wherein the total of the unsaturated groups (i) and (ii) in (a) plus those of the mercaptan groups in (b) is only four, in that the composition is applied as a coating to a substrate, exposed to actinic radiation such that parts of the coating are photopolymerised, and the coating is washed with a dilute aqueous alkaline solution to remove the unpolymerised portions while leaving the photopolymerised portions in place.

10. A compound containing in the molecule

(i) at least one group selected from acryloyloxy and methacryloyloxy groups,

(ii) at least one group selected from allyl, methallyl, and 1-propenyl groups each of which is attached, either directly or through an oxygen atom or an oxycarbonyl group (—OCO—), to a carbon atom which forms part of an aromatic or cycloaliphatic nucleus, and

(iii) at least one carboxylic acid (—COOH) group, being further of one of the formulae

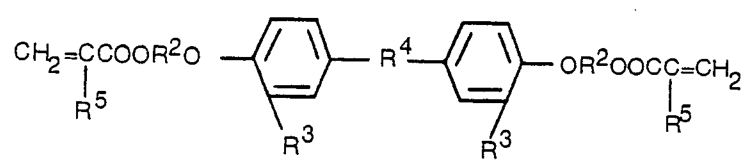
III

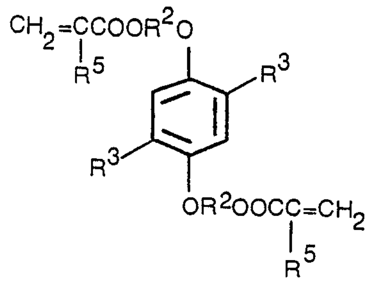
IV

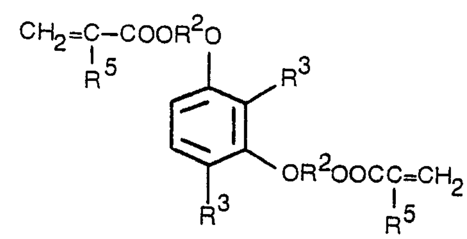
V

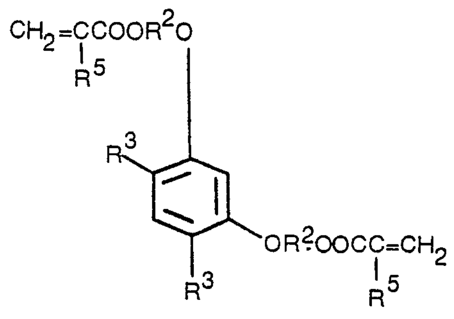
VI

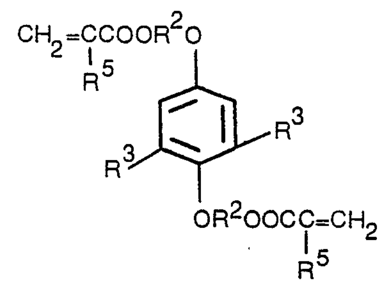
VII

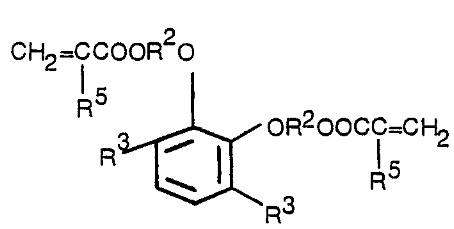
VIII

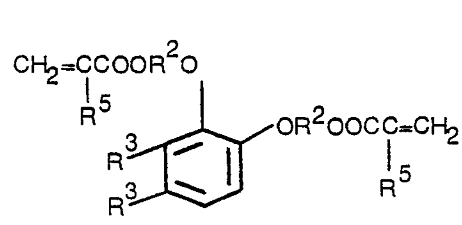
IX

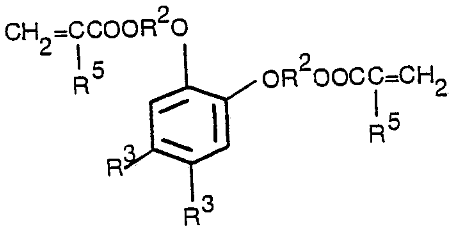
X

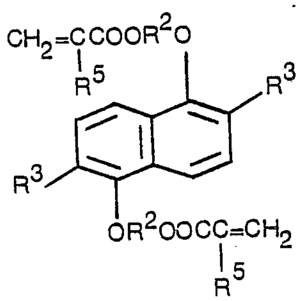
XI

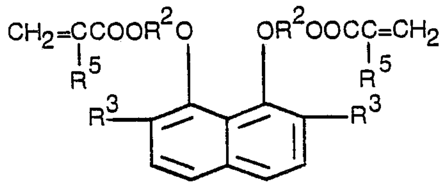
XII

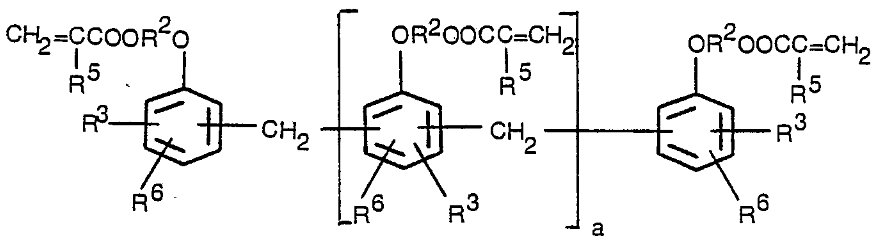
XIII

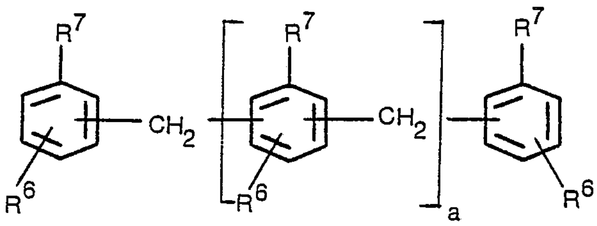
XIV

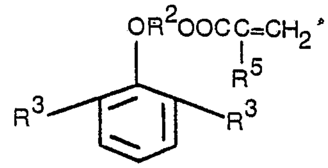
XV

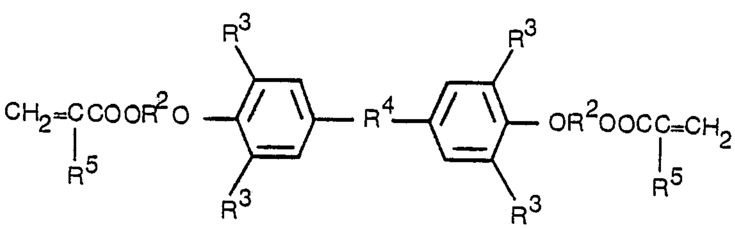
XVI

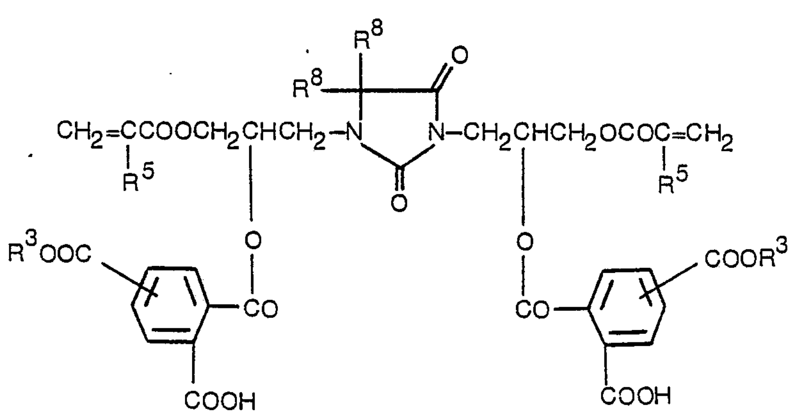
XVII

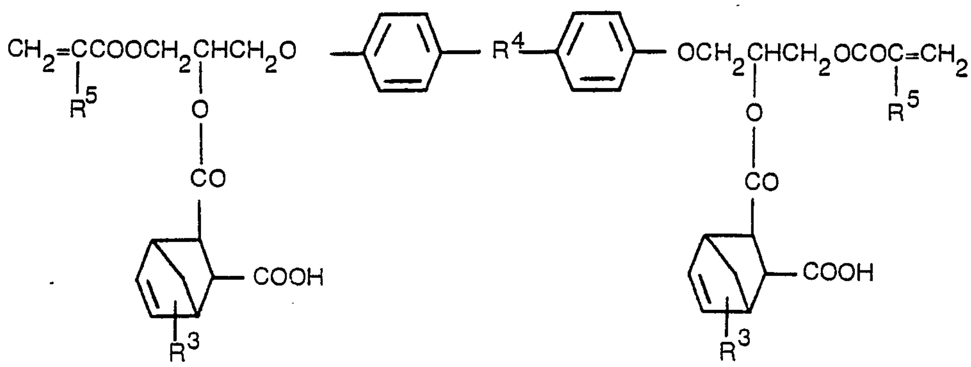

XVIII

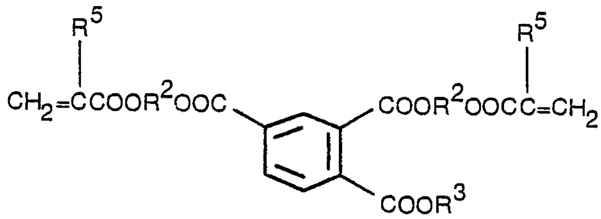

XIX

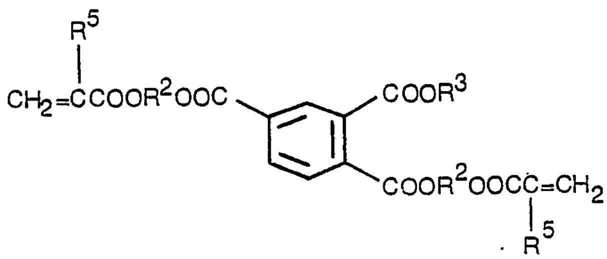

XX

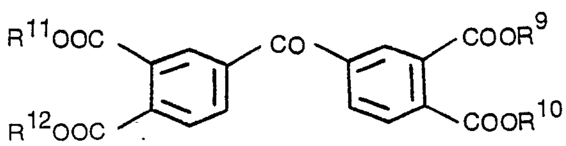

XXI

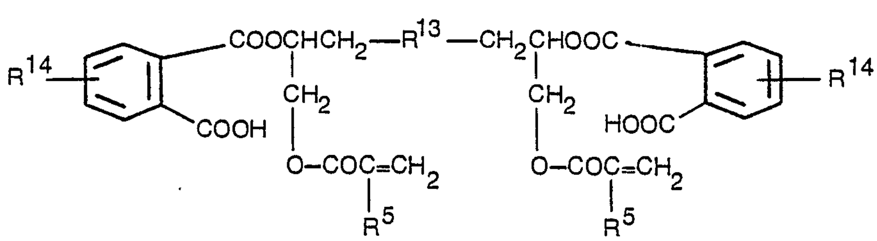

XXIII

where

a is an integer of from 1 to 6,

each $R^2$ denotes a carboxylic acid-containing group of the formula

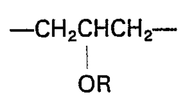

I

wherein R denotes a monovalent acyl radical of an at least dibasic carboxylic acid,

each R3 denotes an allyl, methallyl, or 1-propenyl group, with the proviso that, in formulae XIII and XIV, each —$CH_2$— and $R^3$- group shown is ortho or para to an indicated group $CH_2$=C($R^5$)CO$OR^2$O- and $R^7$-.

$R^4$ denotes a carbon-carbon bond, an alkylene or alkylidene group of up to 5 carbon atoms, an ether oxygen atom, a sulphur atom, or a group of the formula —CO-, —SS-, or —$SO_2$-,

each $R^5$ denotes a hydrogen atom or a methyl group,

each $R^6$ denotes a hydrogen, chlorine, or bromine atom, or an alkyl group of 1 to 4 carbon atoms,

each $R^7$ denotes a group of formula $CH_2$=C($R^5$)CO$OR^2$O— or an allyloxy, methallyloxy, or 1-propenyloxy group such that at least one $R^7$ denotes a said group of the formula $CH_2$=C($R^5$)CO$OR^2$O- and at least two $R^7$ each denotes an allyloxy, methallyloxy, or 1-propenyloxy group, $R^8$ denotes an alkyl group of 1 to 10 carbon atoms, an aralkyl group of 7 to 16 carbon atoms, or an aryl group of 6 to 10 carbon atoms,

one of $R^9$ and $R^{10}$, and one of $R^{11}$ and $R^{12}$, have the same meaning and each donates an allyl or methallyl group, and each of the remaining symbols $R^9$ and $R^{10}$, and $R^{11}$ and $R^{12}$, denote the residue of an alcohol, after removal of the hydrogen atom of an alcoholic hydroxyl group, this residue containing both a carboxylic acid group and an acryloyloxy or methacryloyloxy group,

$R^{13}$ denotes a group of the formula

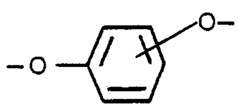

XXIV

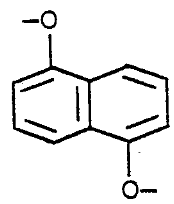

XXV

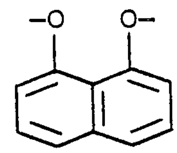

XXVI

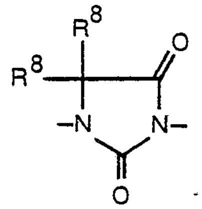

or

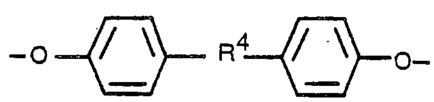

XXVII

XXVIII

and

$R^{14}$ denotes an allyl, methallyl, 1-propenyl, allyloxycarbonyl, methallyloxycarbonyl, 1-propenyloxycarbonyl, diallylamino, dimethylallylamino, or di(1-propenyl)amino group.